(19)

Europäisches Patentamt
European Patent Office
Office européen des brevets

(11)  EP 3 069 426 B1

(12)  **EUROPEAN PATENT SPECIFICATION**

(45) Date of publication and mention of the grant of the patent:
**22.08.2018 Bulletin 2018/34**

(21) Application number: **13897331.8**

(22) Date of filing: **13.11.2013**

(51) Int Cl.:
*H02H 7/00* *(2006.01)*

(86) International application number:
**PCT/CN2013/087091**

(87) International publication number:
**WO 2015/070407 (21.05.2015 Gazette 2015/20)**

(54) **METHOD AND APPARATUS OF REACTOR TURN-TO-TURN PROTECTION**

VERFAHREN UND VORRICHTUNG FÜR EINEN REAKTORWINDUNGSSCHUTZ

PROCÉDÉ ET APPAREIL DE PROTECTION TOUR-À-TOUR DE RÉACTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.09.2016 Bulletin 2016/38**

(73) Proprietor: **Siemens Aktiengesellschaft 80333 München (DE)**

(72) Inventors:
• **CHEN, Deshu Wuhan Hubei 430074 (CN)**
• **CHEN, Wei Wuhan Hubei 430074 (CN)**
• **YANG, Min Nanjing Jiangsu 211100 (CN)**
• **QIN, Leiming Nanjing Jiangsu 211100 (CN)**

• **LI, Jinhui Nanjing Jiangsu 210017 (CN)**
• **GAO, DiJun Nanjing Jiangsu 211100 (CN)**
• **HUANG, Jun Nanjing Jiangsu 210016 (CN)**
• **ZHU, YuKun Wuhan Hubei 430074 (CN)**

(74) Representative: **Patentanwaltskanzlei WILHELM & BECK Prinzenstraße 13 80639 München (DE)**

(56) References cited:
**CN-A- 1 555 116     CN-A- 101 071 151
CN-A- 101 320 908     CN-A- 101 505 051
CN-A- 101 614 779     CN-A- 101 651 328
CN-A- 101 819 242     SU-A1- 678 582**

## Description

### Field of the Invention

The present invention relates to electrical technologies. More particularly, the present invention relates to a method and apparatus of reactor turn-to-turn protection.

### Background of the Invention

For high voltage transmission power grid, one of the most primary characteristic is its large quantities of capacitive charging power. Owing to lack of inductive power, the operating voltage ascends partially and affects the safety and stability of the power systems. For example, capacitive charging power of 500kV transmission line is 6 to 7 times with the same length of 220kV line. To compensate for the capacitive power and depress the overvoltage of the grids, the installation of HV shunt reactors is the most common way to solve above problems. In addition, HV shunt reactors are also widely used to limit the arc current and improve the success rate of single phase auto-reclosing. Essentially, HV shunt reactors consisted by high capacity inductance coils connected to HV transmission lines, which are indispensable elements in the current HV power grids. They play a vital role for stability and security of the whole power system. Same with other electrical equipment, as a consequence, the appropriate protection apparatus is necessary for the operation of HV shunt reactors.

As the voltage level higher and transmission distance longer, the capacity of reactors is became higher and higher. Limited by size, weight and transportation conditions, more and more HV reactors adopt single-phase structure. Hence there seems to be little probability of phase-to-phase faults. The single phase fault and turn-to-turn short circuit are the majors need to be considered. Inter-turn short circuit fault is always a key problem for reactor, as this fault is hardly to be detected. When turn-to-turn short circuit happened with a few turns, the value of the three-phase unbalanced current would be quite small. Measuring at the end of the reactor is difficult to detect variation in the current. These measured values have less obvious characteristics reflected from fault. When turn-to-turn faults happened, the fault current is passed from one terminal to the other. Longitudinal differential current is close to zero. The longitudinal differential protection cannot operate correctly. If reactors adopted with parallel branch structure, the transverse differential protection was able to correctly operation for majority of turn-to-turn faults. However, limited by the structure of the reactor itself, transverse differential protection had limited applied for turn-to-turn faults of reactors..

Early reactor protection didn't configure independent turn-to-turn relay. The clearance of turn-to-turn faults only depends on Non Electrical Quantity Protection, which had a long pick-up time (greater than several hundred milliseconds) and lack of sensitivity in some case. Thus, the turn-to-turn protection scheme becomes a key and difficult point for reactor protection.

Chinese patent CN. 101651328B discloses a method of reactor turn-to-turn protection. This method can improve the sensitivity of inter-turn protection, but it may cause false operation in some transient process. At the same time, overcompensation and under compensation always exist due to the changes of the system operation mode, and the value of zero-sequence compensating voltage is difficult to be determined.

Chinese patent CN. 101505051A provides a method for protecting interturn short circuits of a stator of a power generator based on negative sequence voltage distribution. The method not only reflects various asymmetric failures in the generator, but also can reflect partial internal failures of a main transformer and a transformer for a generator terminal plant; compared with a vertical zero sequence voltage proposal, the method can be easily dualized without increasing primary equipment; when a interphase fault close to the neutral point of the generator is generated, the protection can achieve higher sensibility; and the method can also protect the generator which is not merged into system operation.

Chinese patent CN. 1555116A discloses a method for differentiating unbalance three phases and interturn short circuits by fault-tolerant re-judging to each electricity quantity of the reactor beginning and end when a high voltage parallel reactor operates normally including the following steps: a reactor protection device samples the current, voltage waveforms of mutual-inductor to get the transient value, the plural form of each electricity is evaluated by Fourier algorithm. When the measured zero-sequence voltage is bigger, a phase-comparison relay is used directly, if it's in positive direction, then the master criterion operates. When the zero-sequence voltage is small, the adaptive zero-sequence voltage compensation is carried out to compare the phase, if it's in the positive direction, then the master criterion operates.

### Summary of the Invention

There is a need for providing a good way for reactor protection.

The present invention provides in an aspect a method of reactor turn-to-turn protection, the method comprising:

determining a virtual zero sequence voltage $(\dot{U_0}')$ based on an actual zero sequence current $(\dot{I}_{0f});$ and/or

determining a virtual negative sequence voltage $(\dot{U_2}')$ based on an actual negative sequence current $(\dot{I}_{2f});$
determining a zero sequence operation quantity $(U_{op.0})$ and a zero sequence restraining quantity $(U_{res.0})$ based on an actual zero sequence voltage $(\dot{U_0})$ and the virtual zero sequence voltage $(\dot{U_0}');$ and/or determining a
negative sequence operation quantity $(U_{op.2})$ and a negative sequence restraining quantity $(U_{res.2})$ based on an actual negative sequence voltage $(\dot{U_2})$ and the virtual negative sequence voltage $(\dot{U_2}');$ and
performing a turn-to-turn protection when the zero sequence operation quantity $(U_{op.0})$ is greater than the zero sequence restraining quantity $(U_{res.0})$, and/or when the negative sequence operation quantity $(U_{op.2})$ is greater than the negative sequence restraining quantity $(U_{res.2})$.

In one aspect of the present invention, wherein the method comprising:

acquiring a phase voltage of high voltage end of the reactor and a phase current of low voltage end of the reactor;

determining the actual zero sequence voltage $(\dot{U_0})$ based on the phase voltage of high voltage end, determining the actual zero sequence current $(\dot{I}_{0f})$ based on the phase current of low voltage end.

In one aspect of the present invention, wherein the method comprising:

acquiring a phase voltage of high voltage end of the reactor and a phase current of low voltage end of the reactor;

determining the actual negative sequence voltage $(\dot{U_2})$ based on the phase voltage of high voltage end, determining the actual negative sequence current $(\dot{I}_{2f})$ )based on the phase current of low voltage end.

In one aspect of the present invention, wherein the method comprising:

acquiring an open triangle zero sequence voltage of the high voltage as the actual zero sequence voltage $(\dot{U_0})$

acquiring a CT zero sequence current of the neutral point of the reactor as the actual zero sequence current $(\dot{I}_{0f}).$
In one aspect of the present invention, wherein the method comprising:

judging whether the zero sequence operation quantity $(U_{op.0})$ is greater than the zero sequence restraining quantity

$(U_{res.0})$, when the actual zero sequence voltage $(\dot{U_0})$ is greater than a predetermined zero sequence voltage threshold value, and performing the turn-to-turn protection when the zero sequence operation quantity $(U_{op.0})$ is greater than the zero sequence restraining quantity $(U_{res.0})$; or

judging whether the zero sequence operation quantity $(U_{op.0})$ is greater than the zero sequence restraining quantity

$(U_{res.0})$, when the actual zero sequence current $(\dot{I}_{0f})$ is greater than a predetermined zero sequence current threshold value, and performing the turn-to-turn protection when the zero sequence operation quantity $(U_{op.0})$ is greater than the zero sequence restraining quantity $(U_{res.0})$; or

judging whether the zero sequence operation quantity $(U_{op.0})$ is greater than the zero sequence restraining quantity

$(U_{res.0})$ when the actual zero sequence current $(\dot{I}_{0f})$ is greater than a predetermined zero sequence current threshold value and the actual zero sequence voltage $(\dot{U}_0)$ is greater than a predetermined zero sequence voltage threshold value, and performing the turn-to-turn protection when the zero sequence operation quantity ($U_{op.0}$) is greater than the zero sequence restraining quantity ($U_{res.0}$).

In one aspect of the present invention, wherein the method comprising:

judging whether the negative sequence operation quantity ($U_{op.2}$) is greater than the negative sequence restraining quantity ($U_{res.2}$) when the actual negative sequence voltage $(\dot{U}_2)$ is greater than a predetermined negative sequence voltage threshold value, and performing the turn-to-turn protection when the negative sequence operation quantity ($U_{op.2}$) is greater than the negative sequence restraining quantity ($U_{res.2}$); or

judging whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value, and performing the turn-to-turn protection when the negative sequence operation quantity ($U_{op.2}$) is greater than the negative sequence restraining quantity ($U_{res.2}$); or

judging whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value and the actual negative sequence voltage $(\dot{U}_2)$ is greater than a predetermined negative sequence voltage threshold value, and performing the turn-to-turn protection when the negative sequence operation quantity ($U_{op.2}$) is greater than the negative sequence restraining quantity ($U_{res.2}$).

In one aspect of the present invention, wherein

$$U_{op.0} = |\dot{U}_0 - \dot{U}_0'|, \ U_{res.0} = |\dot{U}_0 + \dot{U}_0'|,$$

$U_{op.0}$ represents the zero sequence operation quantity, $U_{res.0}$ represents the zero sequence restraining quantity, $\dot{U}_0$ represents the actual zero sequence voltage, $\dot{U}_0'$ represents the virtual zero sequence voltage.

In one aspect of the present invention, wherein

$$U_{op.2} = |\dot{U}_2 - \dot{U}_2'|;$$

$$U_{res.2} = |\dot{U}_2 + \dot{U}_2'|;$$

$U_{op.2}$ represents the negative sequence operation quantity, $U_{res.2}$ represents the negative sequence restraining quantity, $\dot{U}_2$ represents the actual negative sequence voltage, $\dot{U}_2'$ represents the virtual negative sequence voltage.

In one aspect of the present invention, wherein the method comprising:

calculating the virtual zero sequence voltage $\dot{U}_0'$,

$$\dot{U}_0' = -\dot{I}_{0f}(Z_L + Z_{s0}');$$

Wherein $\dot{I}_{0f}$ represents the actual zero sequence current, $Z_L$ represents phase reactance of the reactor, $Z_{s0}'$ represents neutral point reactance.

In one aspect of the present invention, wherein the method comprising:

calculating the virtual negative sequence voltage $\dot{U}_2'$ ;

$$\dot{U}_2' = -\dot{I}_{2f} Z_L;$$

$\dot{I}_{2f}$ represents the actual negative sequence current, $Z_L$ represents phase reactance of the reactor.

Further, the present invention provides in an aspect an apparatus of reactor turn-to-turn protection, comprising:

a virtual voltage determining unit, adapted to determine a virtual zero sequence voltage ($\dot{U}_0'$) based on an actual zero sequence current ($\dot{I}_{0f}$); and/or determining a virtual negative sequence voltage ($\dot{U}_2'$) based on an actual negative sequence current ($\dot{I}_{2f}$);

an operation quantity and restraining quantity determining unit, adapted to determine a zero sequence operation quantity ($U_{op.0}$) and a zero sequence restraining quantity ($U_{res.0}$) based on an actual zero sequence voltage ($\dot{U}_0$) and the virtual zero sequence voltage ($\dot{U}_0'$); and/or determine a negative sequence operation quantity ($U_{op.2}$) and a negative sequence restraining quantity ($U_{res.2}$) based on an actual negative sequence voltage ($\dot{U}_2$) and the virtual negative sequence voltage ($\dot{U}_2'$); and

a performing unit, adapted to perform a turn-to-turn protection when the zero sequence operation quantity ($U_{op.0}$) is greater than the zero sequence restraining quantity ($U_{res.0}$) and/or when the negative sequence operation quantity ($U_{op.2}$) is greater than the negative sequence restraining quantity ($U_{res.2}$).

In one aspect of the present invention, the apparatus further comprising:

an acquiring unit, adapted to acquire a phase voltage of high voltage end of the reactor and a phase current of low voltage end of the reactor , to determine the actual zero sequence voltage ($\dot{U}_0$) based on the phase voltage of high voltage end, and to determine the actual zero sequence current ($\dot{I}_{0f}$) based on the phase current of low voltage end.

In one aspect of the present invention, the apparatus further comprising:

an acquiring unit, adapted to acquire a phase voltage of high voltage end of the reactor and a phase current of low voltage end of the reactor and to determine the actual negative sequence voltage ($\dot{U}_2$) based on the phase voltage of high voltage end, and to determine the actual negative sequence current ($\dot{I}_{2f}$) based on the phase current of low voltage end.

In one aspect of the present invention, the apparatus further comprising:

an acquiring unit, adapted to acquire an open triangle zero sequence voltage of the high voltage as the actual zero sequence voltage ($\dot{U}_0$), and to acquire a CT zero sequence current of the neutral point of the reactor as the actual

zero sequence current $(\dot{I}_{0f})$.

In one aspect of the present invention, wherein the performing unit, adapted to:

judge whether the zero sequence operation quantity ($U_{op.0}$) is greater than the zero sequence restraining quantity ($U_{res.0}$) when the actual zero sequence voltage $(\dot{U}_0)$ is greater than a predetermined zero sequence voltage threshold value, and perform the turn-to-turn protection when the zero sequence operation quantity ($U_{op.0}$) is greater than the zero sequence restraining quantity ($U_{res.0}$); or

judge whether the zero sequence operation quantity ($U_{op.0}$) is greater than the zero sequence restraining quantity ($U_{res.0}$) when the actual zero sequence current $(\dot{I}_{0f})$ is greater than a predetermined zero sequence current threshold value, and perform the turn-to-turn protection when the zero sequence operation quantity ($U_{op.0}$) is greater than the zero sequence restraining quantity ($U_{res.0}$); or

judge whether the zero sequence operation quantity ($U_{op.0}$) is greater than the zero sequence restraining quantity ($U_{res.0}$) when the actual zero sequence current $(\dot{I}_{0f})$ is greater than a predetermined zero sequence current threshold value and the actual zero sequence voltage $(\dot{U}_0)$ is greater than a predetermined zero sequence voltage threshold value, and perform the turn-to-turn protection when the zero sequence operation quantity ($U_{op.0}$) is greater than the zero sequence restraining quantity ($U_{res.0}$).

In one aspect of the present invention, wherein the performing unit, adapted to:

judge whether the negative sequence operation quantity ($U_{op.2}$) is greater than the negative sequence restraining quantity ($U_{res.2}$) when the actual negative sequence voltage $(\dot{U}_2)$ is greater than a predetermined negative sequence voltage threshold value, and perform the turn-to-turn protection when the negative sequence operation quantity ($U_{op.2}$) is greater than the negative sequence restraining quantity ($U_{res.2}$); or

judge whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value, and perform the turn-to-turn protection when the negative sequence operation quantity ($U_{op.2}$) is greater than the negative sequence restraining quantity ($U_{res.2}$); or

judge whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value and the actual negative sequence voltage $(\dot{U}_2)$ is greater than a predetermined negative sequence voltage threshold value, and perform the turn-to-turn protection when the negative sequence operation quantity ($U_{op.2}$) is greater than the negative sequence restraining quantity ($U_{res.2}$).

In one aspect of the present invention, wherein

$$U_{op.0} = |\dot{U}_0 - \dot{U}_0'|, \quad U_{res.0} = |\dot{U}_0 + \dot{U}_0'|,$$

$U_{op.0}$ represents the zero sequence operation quantity, $U_{res.0}$ represents the zero sequence restraining quantity, $\dot{U}_0$ represents the actual zero sequence voltage, $\dot{U}_0'$ represents the virtual zero sequence voltage.

In one aspect of the present invention, wherein

$$U_{op.2} = |\dot{U}_2 - \dot{U}_2'|;$$

$$U_{res.2} = |\dot{U}_2 + \dot{U}_2'|;$$

$U_{op.2}$ represents the negative sequence operation quantity, $U_{res.2}$ represents the negative sequence restraining quantity, $\dot{U}_2$ represents the actual negative sequence voltage, $\dot{U}_2'$ represents the virtual negative sequence voltage.

In one aspect of the present invention, wherein the virtual voltage determining unit, adapted to calculate the virtual zero sequence voltage $\dot{U}_0'$,

$$\dot{U}_0' = -\dot{I}_{0f}(Z_L + Z_{s0}');$$

Wherein $\dot{I}_{0f}$ represents the actual zero sequence current, $Z_L$ represents phase reactance of the reactor, $Z_{s0}'$ represents neutral point reactance.

In one aspect of the present invention, wherein the virtual voltage determining unit, adapted to calculate the virtual negative sequence voltage $\dot{U}_2'$;

$$\dot{U}_2' = -\dot{I}_{2f} Z_L;$$

$\dot{I}_{2f}$ represents the actual negative sequence current, $Z_L$ represents phase reactance of the reactor.

It can be seen that the present invention is simple, intuitive, less affected by the variance of system operating mode and has higher sensitivity and reliability.

**Brief Description of Drawings**

Figure 1 represents a flow chart depicting a method of reactor turn-to-turn protection according to the present invention.

Figure 2 represents zero sequence networks respectively when turn-to-turn short circuit or external earth fault occurred according to the present invention.

Figure 3 represents the phase relationships of $\dot{U}_0$, $U_0'$, $U_{op}$ and $\dot{U}_{res}$.

Figure 4 represents a structure drawing depicting an apparatus of reactor turn-to-turn protection according to the present invention.

Figure 5 represents a structure drawing depicting an exemplary apparatus of reactor turn-to-turn protection according to the present invention.

Figure 6 represents a simulation model according to the present invention.

Figure 7 represents a three-phase reactor model constructed by single-phase transformers according to the present invention.

Figure 8 represents waveforms of zero sequence variables under normal operation condition according to the present invention.

Figure 9 represents waveforms of negative sequence variables under normal operation condition according to the present invention.

Figure 10 represents waveforms of zero sequence variables when 50% turn-to-turn short circuit happened in the head according to the present invention.

Figure 11 represents waveforms of negative sequence variables when 50% turn-to-turn short circuit happened in the head according to the present invention.

Figure 12 represents waveforms of zero sequence variables when 50% turn-to-turn short circuit happened in the middle according to the present invention.

Figure 13 represents waveforms of negative sequence variables when 50% turn-to-turn short circuit happened in the middle according to the present invention.

Figure 14 represents waveforms of zero sequence variables when 50% turn-to-turn short circuit happened in the end according to the present invention.

Figure 15 represents waveforms of negative sequence variables when 50% turn-to-turn short circuit happened in the end according to the present invention.

Figure 16 represents waveforms of zero sequence variables when 1.7% turn-to-turn short circuit happened in the head according to the present invention.

Figure 17 represents waveforms of negative sequence variables when 1.7% turn-to-turn short circuit happened in the head according to the present invention

Figure 18 represents waveforms of zero sequence variables when 1.7% turn-to-turn short circuit happened in the middle according to the present invention.

Figure 19 represents waveforms of negative sequence variables when 1.7% turn-to-turn short circuit happened in the middle according to the present invention.

Figure 20 represents waveforms of zero sequence variables when 1.7% turn-to-turn short circuit happened in the end according to the present invention.

Figure 21 represents waveforms of negative sequence variables when 1.7% turn-to-turn short circuit happened in the end according to the present invention.

Figure 22 represents waveforms of zero sequence variables when external fault of short distance happened according to the present invention.

Figure 23 represents waveforms of negative sequence variables when external fault of short distance happened according to the present invention.

Figure 24 represents waveforms of zero sequence variables when external fault of long distance happened according to the present invention.

Figure 25 represents waveforms of negative sequence variables when external fault of long distance happened according to the present invention.

Figure 26 represents waveforms of zero sequence variables for two phase operation and single-phase reclosing according to the present invention.

Figure 27 represents waveforms of negative sequence variables for two phase operation and single-phase reclosing according to the present invention.

Figure 28 represents waveforms of zero sequence variables when external fault of long distance happened and the transformer has a rather small reactance according to the present invention.

Figure 29 represents waveforms of negative sequence variables when external fault of long distance happened and the transformer has a rather small reactance according to the present invention.

## Detailed Description of the Invention

The present invention disclosures a new reactor inter-turn (turn-to-turn) short circuit detection solution.
In one aspect of the present invention, a method of reactor turn-to-turn protection is provided based on virtual voltage algorithm. Figure 1 represents a flow chart depicting a method of reactor turn-to-turn protection according to the present invention.
As illustrated by figure 1, the method comprises following steps:
Step 101: determining a virtual zero sequence voltage based on an actually measured zero sequence current (or say, actual zero sequence current); and/or determining a virtual negative sequence voltage based on an actually measured negative-sequence current (or say, actual negative sequence current).

In one embodiment, the virtual zero-sequence voltage $\dot{U}_0{}'$ is calculated by the following formula:

$$\dot{U}_0{}' = -\dot{I}_{0f}(Z_L + Z_{s0}{}');$$

Wherein $\dot{I}_{0f}$ represents the actual zero-sequence current, $Z_L$ represents phase reactance of the reactor, $Z_{s0}{}'$ represents neutral point reactance.

In one embodiment, the virtual negative-sequence voltage $\dot{U}_2{}'$ is calculated by the following formula:

$$\dot{U}_2{}' = -\dot{I}_{2f}Z_L;$$

Wherein $\dot{I}_{2f}$ represents the actual negative sequence current, $Z_L$ represents phase reactance of the reactor.
In one embodiment, a phase voltage of high voltage end of the reactor and a phase current of low voltage end of the reactor are acquired; and the actual zero sequence voltage is determined based on the phase voltage of high voltage end, the actual zero sequence current is determined based on the phase current of low voltage end.
In one embodiment, a phase voltage of high voltage end of the reactor and a phase current of low voltage end of the reactor are acquired; and the actual negative sequence voltage is determined based on the phase voltage of high voltage end, the actual negative sequence current is determined based on the phase current of low voltage end.
In one embodiment, an open triangle zero sequence voltage of the high voltage is obtained as the actual zero sequence voltage, and a CT zero sequence current of the neutral point of the reactor is obtained as the actual zero sequence current.
Step 102: determining a zero sequence operation quantity and a zero sequence restraining quantity based on an actual zero sequence voltage and the virtual zero sequence voltage; and/or determining a negative sequence operation quantity and a negative sequence restraining quantity based on an actual negative sequence voltage and the virtual z negative sequence voltage.
In one embodiment, it is to judge whether the zero sequence operation quantity is greater than the zero sequence restraining quantity when the actual zero sequence voltage is greater than a predetermined zero sequence voltage threshold value, and performing the turn-to-turn protection when the zero sequence operation quantity is greater than the zero sequence restraining quantity.

In one embodiment, it is to judge whether the zero sequence operation quantity is greater than the zero sequence restraining quantity when the actual zero sequence current is greater than a predetermined zero sequence current threshold value, and performing the turn-to-turn protection when the zero sequence operation quantity is greater than the zero sequence restraining quantity.

Preferably, in one embodiment, it is to judge whether the zero sequence operation quantity is greater than the zero sequence restraining quantity when the actual zero sequence current is greater than a predetermined zero sequence current threshold value and the actual zero sequence voltage is greater than a predetermined zero sequence voltage threshold value, and performing the turn-to-turn protection when the zero sequence operation quantity is greater than the zero sequence restraining quantity.

In one embodiment, it is to judge whether the negative sequence operation quantity is greater than the negative sequence restraining quantity when the actual negative sequence voltage is greater than a predetermined negative sequence voltage threshold value, and performing the turn-to-turn protection when the negative sequence operation quantity is greater than the negative sequence restraining quantity.

In one embodiment, it is to judge whether the negative sequence operation quantity is greater than the negative sequence restraining quantity when the actual negative sequence current is greater than a predetermined negative sequence current threshold value, and performing the turn-to-turn protection when the negative sequence operation quantity is greater than the negative sequence restraining quantity.

Preferably, in one embodiment, it is to judge whether the negative sequence operation quantity is greater than the negative sequence restraining quantity, when the actual negative sequence current is greater than a predetermined negative sequence current threshold value and the actual negative sequence voltage is greater than a predetermined negative sequence voltage threshold value, and performing the turn-to-turn protection when the negative sequence operation quantity is greater than the negative sequence restraining quantity.

In one embodiment, $U_{op.0} = |\dot{U}_0 - \dot{U}_0'|$ ; $U_{res.0} = |\dot{U}_0 + \dot{U}_0'|$ ; $U_{op.0}$ represents the zero sequence operation quantity, $U_{res.0}$ represents the zero sequence restraining quantity, $\dot{U}_0$ represents the actual zero sequence voltage, $\dot{U}_0'$ represents the virtual zero sequence voltage.

In one embodiment, $U_{op.2} = |\dot{U}_2 - \dot{U}_2'|$ ; $U_{res.2} = |\dot{U}_2 + \dot{U}_2'|$ ; wherein $U_{op.2}$ represents the negative sequence operation quantity, $U_{res.2}$ represents the negative sequence restraining quantity, $\dot{U}_2$ represents the actual negative sequence voltage, $\dot{U}_2'$ represents the virtual negative sequence voltage.

Step103: performing a turn-to-turn protection when the zero sequence operation quantity is greater than the zero sequence restraining quantity, and/or when the negative sequence operation quantity is greater than the negative sequence restraining quantity.

Preferably, in one embodiment, the step of performing a turn-to-turn protection may include the step of sending trip instructions to a breaker connected to the high voltage end of the reactor.

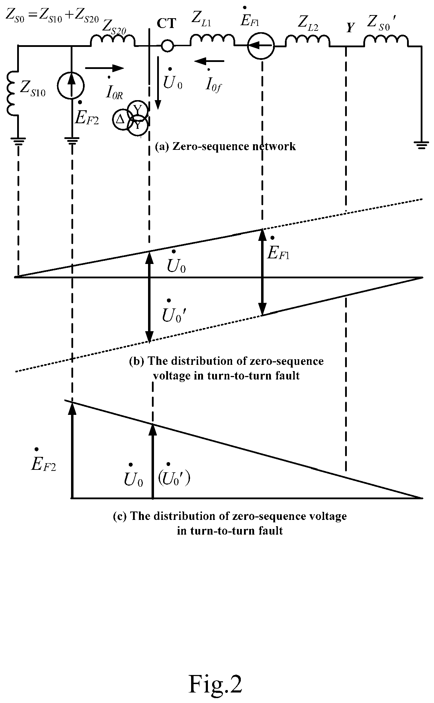

Figure 2 shows zero sequence networks respectively when turn-to-turn short circuit or external earth fault occurred according to the present invention.

According to the superposition principle, zero sequence networks are shown in Figure 2(a). $\dot{E}_{F1}$ 、 $\dot{E}_{F2}$ are the equivalent power sources in the zero sequence networks respectively when turn-to-turn short circuit or external earth fault occurred.

When turn-to-turn fault occurs, the relationship between the measured zero sequence current $\dot{I}_{0f}$ and voltage $\dot{U}_0$ can be expressed as:

$$\dot{U}_0 = \dot{I}_{0f} Z_{S0} \qquad (1)$$

According to the defined direction in Figure 2 (a), the zero sequence current $\dot{I}_{0f}$, zero sequence impedance $Z_L = Z_{L1} + Z_{L2}$ and neutral point reactance $Z_{s0}'$ can be used to create a virtual voltage:

$$\overset{\bullet}{U}_0{}' = -\overset{\bullet}{I}_{0f}(Z_L + Z_{s0}{}') \qquad (2)$$

By comparing formula (1) and (2), it can be seen that the phases of the virtual zero sequence voltage and the actually measured zero sequence voltage are totally opposite, which is shown in Figure 2 (b).

From formula (1) and (2), we can obtain:

$$\overset{\bullet}{U}_0 - \overset{\bullet}{U}_0{}' = \overset{\bullet}{I}_{0f}(Z_{S0} + Z_L + Z_{S0}{}') \qquad (3)$$

Obviously, when turn-to-turn short circuit occurred, as long we will always obtain as $\overset{\bullet}{I}_{0f}$ can be measured,:

$$|\overset{\bullet}{U}_0 - \overset{\bullet}{U}_0{}'| = |\overset{\bullet}{I}_{0f}(Z_{S0} + Z_L + Z_{S0}{}')| > 0 \qquad (4)$$

When ground fault occurs outside the reactor, the relationship between the zero sequence current $\overset{\bullet}{I}_{0R}$ and zero sequence voltage $\overset{\bullet}{U}_0$ measured in the location where the protection is installed can be expressed as:

$$\overset{\bullet}{U}_0 = \overset{\bullet}{I}_{0R}(Z_L + Z_{S0}{}') \qquad (5)$$

Similarly to formula (2), we can use the zero-sequence current $\overset{\bullet}{I}_{0R}$, zero-sequence impedance $Z_L = Z_{L1} + Z_{L2}$ and reactance $Z_{s0}{}'$ of neutral point to construct a virtual calculated zero-sequence voltage:

$$\overset{\bullet}{U}_0{}' = \overset{\bullet}{I}_{0R}(Z_L + Z_{S0}{}') \qquad (6)$$

Obviously, as shown in Fig 2 (c), comparing formula (5) and (6), we can see that their expressions are identical:

$$|\overset{\bullet}{U}_0 - \overset{\bullet}{U}_0{}'| = 0 \qquad (7)$$

According to the above analysis, respectively, set the operation amount $U_{op} = |\overset{\bullet}{U}_0 - \overset{\bullet}{U}_0{}'|$, the restraint amount $U_{res} = |\overset{\bullet}{U}_0 + \overset{\bullet}{U}_0{}'|$.

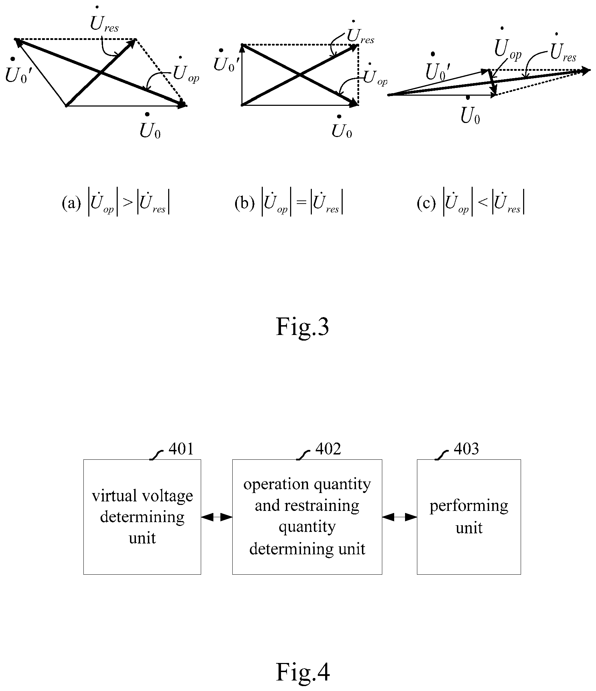

Vectors relationship in the complex plane is shown in Figure 3, $\dot{U}_{op}$ and $\dot{U}_{res}$ are diagonal lines of the parallelogram whose side length is $\dot{U}_0$ and $\overset{\bullet}{U}_0{}'$.

When internal turn-to-turn fault happened to the reactor, as shown in Figure 3(a), $\dot{U}_0$ and $\overset{\bullet}{U}_0{}'$ have different phases, whose difference should be 180° theoretically, however, subject to the measurement error and other factors,

$$90^0 < \arg \frac{\dot{U}_0}{\overset{\bullet}{U}_0{}'} < 270^0,$$
and it is easy to see from the characteristics of the parallelogram that $|\dot{U}_{op}| > |\dot{U}_{res}|$.

Theoretically, when the phase angle between $\dot{U}_0$ and $\overset{\bullet}{U}_0{}'$ is 90° or 270° as shown in Figure 3 (b), there will be $|\dot{U}_{op}| = |\dot{U}_{res}|$, which is the boundary of operation characteristics.

In practice, as long as the measurement error is in the acceptable range, the phase angle between $\dot{U}_0$ and $\overset{\bullet}{U}_0{}'$ is impossible close to 90° or 270°.

When the external ground fault occurred, the current measured by reactor is a reversed current. As shown in

figure 3(c), $\dot{U}_0$ and $\dot{U}_0'$ are approximately equal.

Under this condition, the restraining quantity $U_{res} = \left|\dot{U}_{res}\right| = |\dot{U}_0 + \dot{U}_0'|$ is approximately equal to twice $U_0$ and the operation quantity $U_{op} = \left|\dot{U}_{op}\right| = |\dot{U}_0 - \dot{U}_0'|$ is approximately equal to zero. It is obviously $|\dot{U}_{op}| << |\dot{U}_{res}|$.

From what has been discussed above, the criterion of turn-to-turn protection of reactors can be expressed as:

$$U_{op} > U_{res} \qquad\qquad (8)$$

In order to take account of the sensitivity and reliability requirements of the various operating conditions, referring to the negative sequence power directional protection theory, a novel negative sequence components criterion be proposed similarly.

The combined criterion can be described as follows:

The Zero sequence criterion:

Set $U_{op.0} = |\dot{U}_0 - \dot{U}_0'|$ and $U_{res.0} = |\dot{U}_0 + \dot{U}_0'|$, then:

$$U_{op.0} > U_{res.0} \qquad\qquad (9)$$

The Negative sequence criterion:

Set $U_{op.2} = |\dot{U}_2 - \dot{U}_2'|$ and $U_{res.2} = |\dot{U}_2 + \dot{U}_2'|$, then:

$$U_{op.2} > U_{res.2} \qquad\qquad (10)$$

$\dot{U}_2$ is the negative sequence voltage measured in the location where the protection is installed. $\dot{U}_2'$ is the virtual negative sequence voltage similar to $\dot{U}_0'$.

In most cases, the sensitivity of the negative sequence power directional protection is higher than the sensitivity of the zero sequence power directional protection. But we can see through the existing simulation test, in the internal ground fault, the sensitivity of the zero sequence power directional protection is higher than the sensitivity of the negative sequence power direction protection. Therefore, for reactor turn-to-turn protection program, zero sequence and negative sequence power directional protection can match and coordinate each other.

Because the cooperation of zero sequence criterion (9) and negative sequence criterion (10) has higher reliability for external fault to prevent false operation, so we tend to use the program with higher sensitivity. The comprehensive turn-to-turn protection criterion can improve both reliability and sensitivity.

In one embodiment, the zero sequence and negative sequence thresholds are used to prevent the incorrect operation when zero and negative sequence voltages are so small to dissatisfy the measurement accuracy. By taking into account the measurement error less than 5% of the rated value generally, the setting value can generally be not more than 5% of the rated value.

The present invention is preferably suitable for HV(High Voltage) reactor turn-to-turn protection.

The present invention also discloses an apparatus of reactor turn-to-turn protection.

Figure 4 is a block diagram of an apparatus of reactor turn-to-turn protection according to the present invention.

As illustrated by figure 4, the apparatus of reactor turn-to-turn protection, comprising:

a virtual voltage determining unit 401, adapted to determine a virtual zero sequence voltage based on an actual zero sequence current; and/or determining a virtual negative sequence voltage based on an actual negative sequence current;

an operation quantity and restraining quantity determining unit 402, adapted to determine a zero sequence operation quantity and a zero sequence restraining quantity based on an actual zero sequence voltage and the virtual zero sequence voltage; and/or determine a negative sequence operation quantity and a negative sequence restraining quantity based on an actual negative sequence voltage and the virtual negative sequence voltage;

a performing unit 403, adapted to perform a turn-to-turn protection when the zero sequence operation quantity is greater than the zero sequence restraining quantity and/or when the negative sequence operation quantity is greater than the negative sequence restraining quantity.

In one embodiment, the apparatus further comprising:
an acquiring unit (not illustrated), adapted to acquire a phase voltage of high voltage end of the reactor and a phase current of low voltage end of the reactor and to determine the actual zero sequence voltage based on the phase voltage of high voltage end, and to determine the actual zero sequence current based on the phase current of low voltage end.

In one embodiment, the apparatus further comprising:
an acquiring unit (not illustrated), adapted to acquire a phase voltage of high voltage end of the reactor and a phase current of low voltage end of the reactor and to determine the actual negative sequence voltage based on the phase voltage of high voltage end, to determine the actual negative sequence current based on the phase current of low voltage end.

In one embodiment, the apparatus further comprising:
an acquiring unit (not illustrated), adapted to acquire an open triangle zero sequence voltage of the high voltage as the actual zero sequence voltage, and to acquire a CT zero sequence current of the neutral point of the reactor as the actual zero sequence current.

In one embodiment, the performing unit 403, adapted to judge whether the zero sequence operation quantity is greater than the zero sequence restraining quantity when the actual zero sequence voltage is greater than a predetermined zero sequence voltage threshold value, and performing the turn-to-turn protection when the zero sequence operation quantity is greater than the zero sequence restraining quantity.

In one embodiment, the performing unit 403, adapted to judge whether the zero sequence operation quantity is greater than the zero sequence restraining quantity when the actual zero sequence current is greater than a predetermined zero sequence current threshold value, and performing the turn-to-turn protection when the zero sequence operation quantity is greater than the zero sequence restraining quantity.

Preferably, In one embodiment, the performing unit 403, adapted to judge whether the zero sequence operation quantity is greater than the zero sequence restraining quantity when the actual zero sequence current is greater than a predetermined zero sequence current threshold value and the actual zero sequence voltage is greater than a predetermined zero sequence voltage threshold value, and to perform the turn-to-turn protection when the zero sequence operation quantity is greater than the zero sequence restraining quantity.

In one embodiment, the performing unit 403, adapted to judge whether the negative sequence operation quantity is greater than the negative sequence restraining quantity when the actual negative sequence voltage is greater than a predetermined negative sequence voltage threshold value, and toperforme the turn-to-turn protection when the negative sequence operation quantity is greater than the negative sequence restraining quantity.

In one embodiment, the performing unit 403, adapted to judge whether the negative sequence operation quantity is greater than the negative sequence restraining quantity when the actual negative sequence current is greater than a predetermined negative sequence current threshold value, and performing the turn-to-turn protection when the negative sequence operation quantity is greater than the negative sequence restraining quantity; or
Preferably, in one embodiment, the performing unit 403, adapted to judge whether the negative sequence operation quantity is greater than the negative sequence restraining quantity when the actual negative sequence current is greater than a predetermined negative sequence current threshold value and the actual negative sequence voltage is greater than a predetermined negative sequence voltage threshold value, and to perform the turn-to-turn protection when the negative sequence operation quantity is greater than the negative sequence restraining quantity.

$$U_{op.0} = |\dot{U}_0 - \dot{U}_0'|, \quad U_{res.0} = |\dot{U}_0 + \dot{U}_0'|,$$

In one embodiment, wherein $U_{op.0}$ represents the zero sequence operation quantity, $U_{res.0}$ represents the zero sequence restraining quantity, $\dot{U}_0$ represents the actual zero sequence voltage, $\dot{U}_0'$ represents the virtual zero sequence voltage.

In one embodiment, wherein $U_{op.2} = |\dot{U}_2 - \dot{U}_2'|; \quad U_{res.2} = |\dot{U}_2 + \dot{U}_2'|;$

13

$U_{op.2}$ represents the negative sequence operation quantity, $U_{res.2}$ represents the negative sequence restraining quantity, $\dot{U}_2$ represents the actual negative sequence voltage, $\dot{U}_2'$ represents the virtual negative sequence voltage.

In one embodiment, wherein the virtual voltage determining unit, adapted to calculate the actual zero sequence voltage $\dot{U}_0'$,

$$\dot{U}_0' = -\dot{I}_{0f}(Z_{\mathrm{L}} + Z_{s0}')$$

$\dot{I}_{0f}$ represents the actual zero sequence current, $Z_{\mathrm{L}}$ represents phase reactance of the reactor, $Z_{s0}'$ represents neutral point reactance.

In one embodiment, wherein the virtual voltage determining unit, adapted to calculate the virtual negative sequence voltage $\dot{U}_2'$ ;

$$\dot{U}_2' = -\dot{I}_{2f}Z_{\mathrm{L}} ;$$

$\dot{I}_{2f}$ represents the actual negative sequence current, $Z_{\mathrm{L}}$ represents phase reactance of the reactor

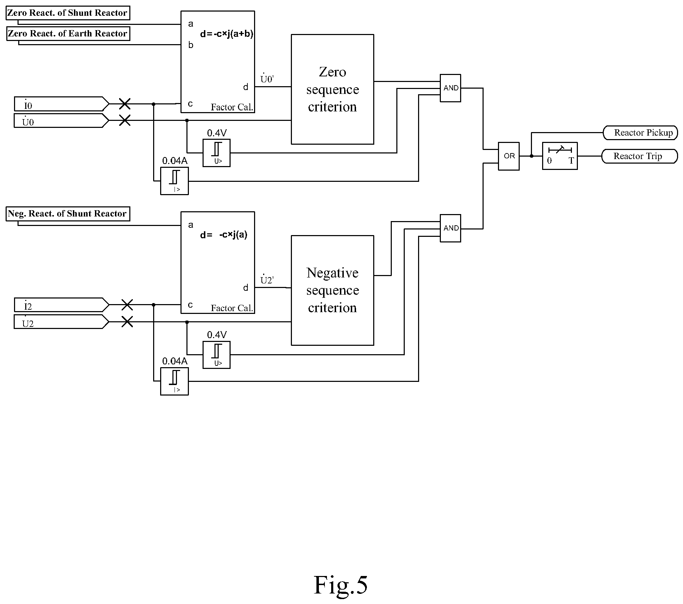

Figure 5 shows a block diagram of an exemplary apparatus of reactor turn-to-turn protection according to the present invention.

As illustrated by figure 5, the apparatus of reactor turn-to-turn protection employs some gate circuits to perform a turn-to-turn protection. That is, a turn-to-turn protection action is performed when the zero sequence operation quantity is greater than the zero sequence restraining quantity or when the negative sequence operation quantity is greater than the negative sequence restraining quantity. In addition, an AND gate is respectively used in zero sequence criterion judgment and negative sequence criterion judgment to respectively limit the zero sequence voltage and zero sequence current.

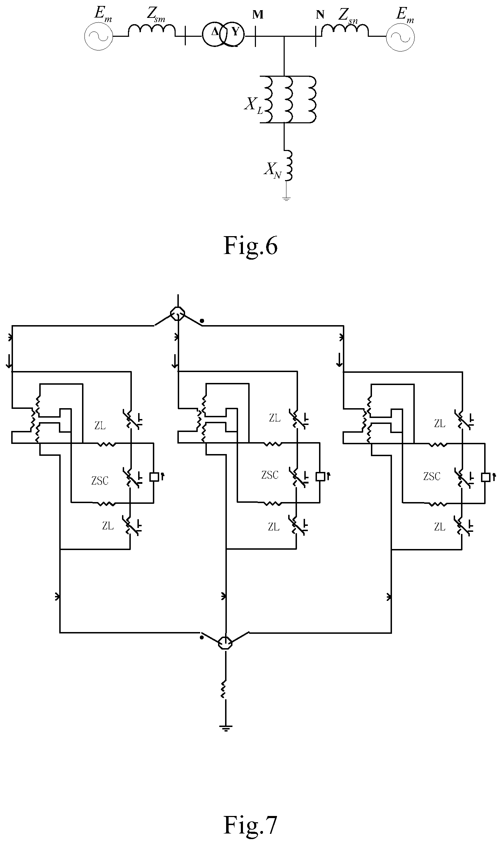

In order to verify the protection principle in a variety of operating conditions, in accordance with the typical configuration in power system of 500kV, PSCAD / EMTDC simulation software has been used to simulate faults, normal and abnormal operating conditions. Establish the simulation model as shown in Figure 6, where the voltage and current are taken from the high voltage end of the reactor.

The basic parameters of the experimental model[18] are shown as follows:

Transformer connection: Yn, $d$ ll;
power source:$E_m$=230kV, $Z_{sm}$=1.05+j137.5($\Omega$), $E_n$=525kV, $Z_{sn}$=1.06+143.06($\Omega$);
Transmission lines:$R$=0.02083$\Omega$/km, $L$=0.8984 mH /km;
Reactor:$X_L$=2000$\Omega$, $X_N$=62.5$\Omega$;
The length of transmission lines: 300km.

The digital simulation software PSCAD / EMTDC does not have ready reactor model. Considering the difficulty of implement turn-to-turn faults and the approximation of actual reactor magnetic coupling relationship, the single-phase transformers are used to simulate the reactor in the digital simulation as shown in Figure 7.

Some literatures use autotransformer to build reactor simulation model. The disadvantage of this method is that the magnetic coupling between the coil and the iron core is too strong. Actually, the coil and the core is still some coupling in the event of an inter-turn short circuit, but the strength is limited because of the existence of air gap in the actual reactor core. However, when we use ordinary inductor for simulation, the mutual inductance is completely zero, which is also not realistic. Therefore, the present invention plans to change the coupling relationship by adjusting the intermediate inductor L.

Normal operation:

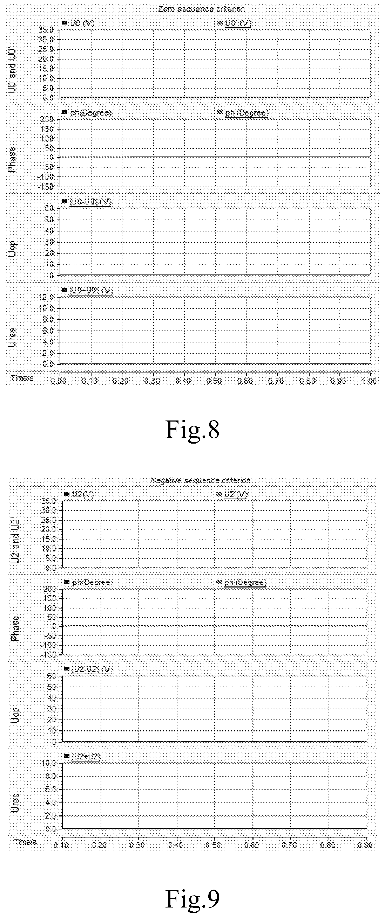

When the power system is under normal operation condition, there is no zero-sequence component. As a result, thus the zero-sequence voltage $\dot{U}_0$, virtual zero-sequence voltage $\dot{U}_0'$, $|\dot{U}_0-\dot{U}_0'|$ and $|\dot{U}_0+\dot{U}_0'|$ are zero, negative sequence components have the same results. Under these conditions, the protection has adequate redundancy to keep non-operation. The simulation waveform diagrams are shown in figure 8-9. Figure 8 represents waveforms of zero sequence variables under normal operation condition according to the present invention. Figure 9 represents waveforms of negative sequence variables under normal operation condition according to the present invention.

50% turn-to-turn short circuit fault:

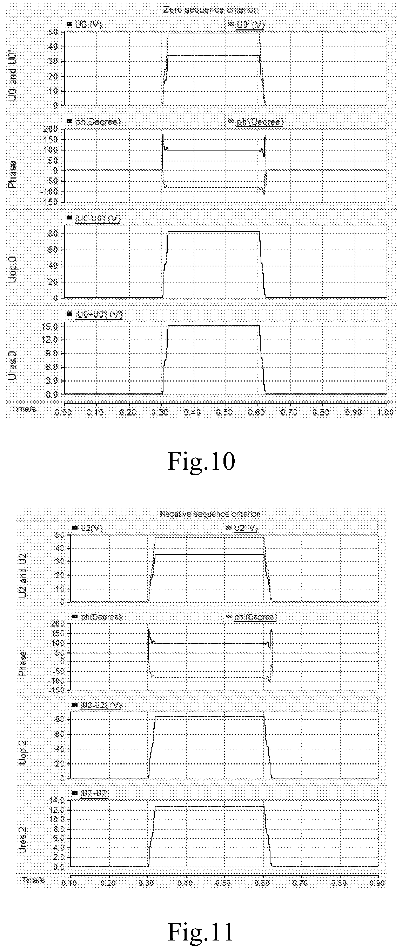

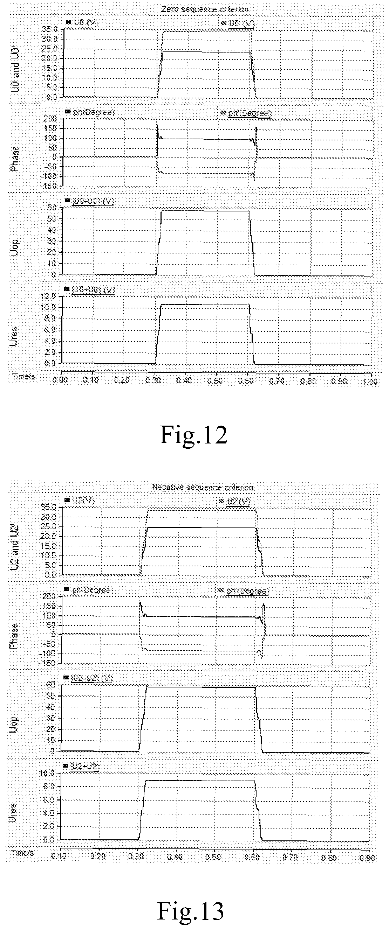

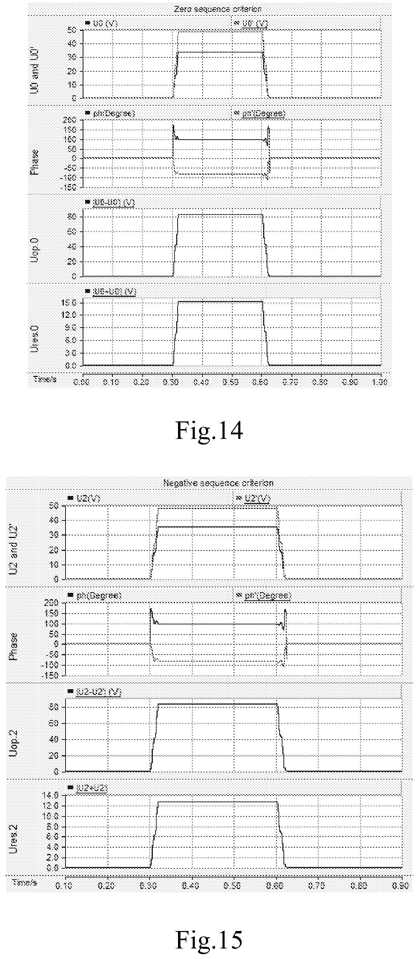

At 0.3 second, the phase A will have 50% turn-to-turn short circuit in the head, middle and end of the reactor respectively. The waveforms of relative zero and negative sequence voltages and operation quantity $U_{op}$ and restraint quantity $U_{res}$ obtained by simulation are shown in figure 10-11, 12-13 and 14-15.

In these figures, it is obviously that $U_{op}$ is greater than $U_{res}$. Furthermore the negative sequence criterion has higher sensitivity. The protection can quickly and reliably clear the fault.

1.7% turn-to-turn short-circuit fault:

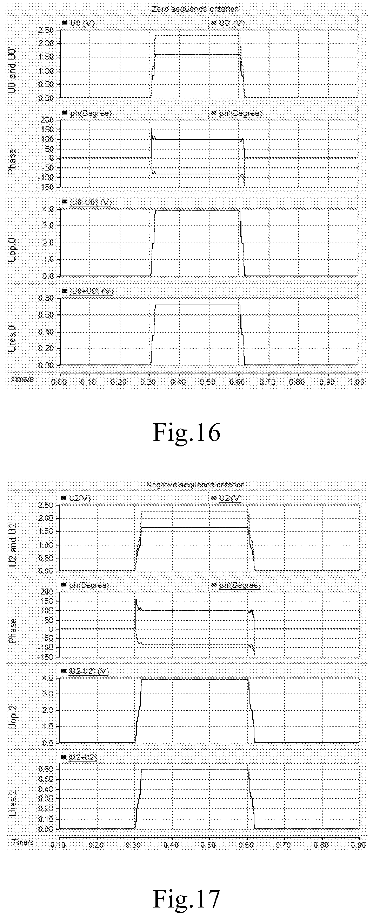

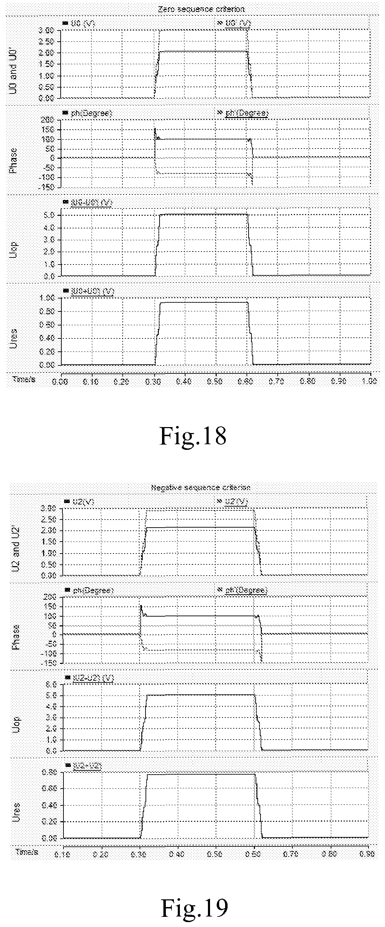

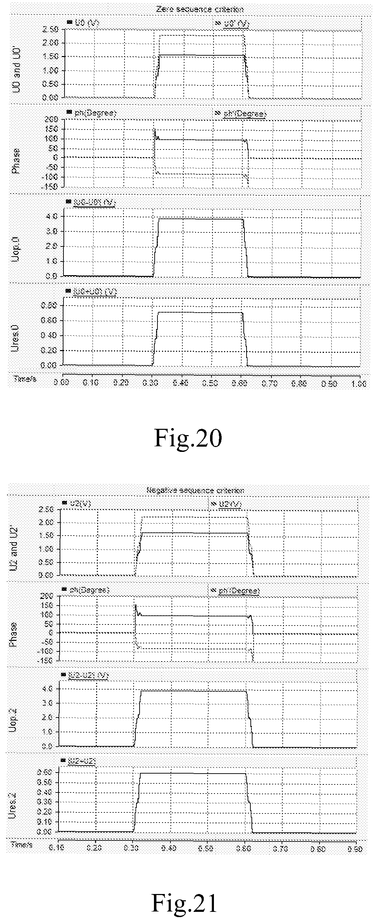

Waveforms of zero and negative sequence variables when 1.7% turn-to-turn short circuit occurred is shown in figure 16-17, 18-19 and 20-21.

According to the figures, it can be seen that 1.7% inter-turn short circuit occurred, the amplitude of the zero sequence voltage $\dot{U}_0$ is relatively small, but the existence of the virtual zero sequence voltage $\dot{U}_0'$ made the operation quantity $U_{op}$ is still greater than the restraint quantity $U_{res}$. The negative sequence criterion has similar results with higher sensitivity, the protection can clear fault reliably.

External fault of short distance:

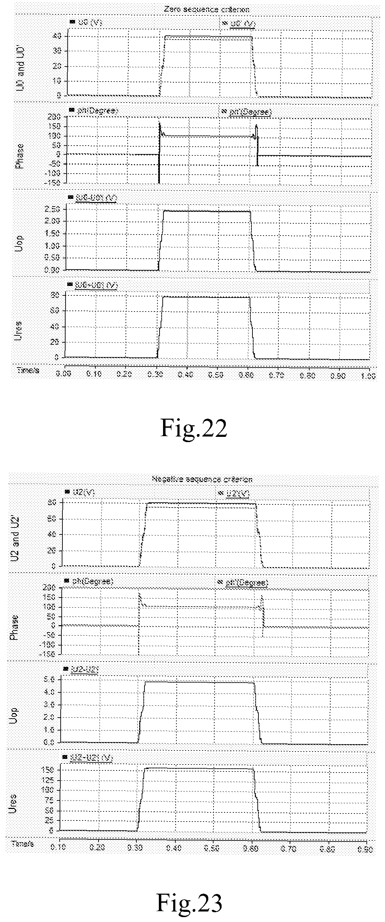

When single-phase ground fault happened to the transmission lines with short distance, the related waveform is shown in Figure 22-23. Here $\dot{U}_0$ is almost exactly equal to the virtual zero sequence voltage $\dot{U}'_0$ They have the same magnitude and phase. $|\dot{U}_0-\dot{U}_0'|$ is close to zero and $|\dot{U}_0+\dot{U}_0'|$ is approximately equal to double $|\dot{U}_0|$. So the operation quantity $U_{op}$ is far less than the restraint quantity $U_{res}$. The negative sequence criterion has the same results. In summary, protection will not operate.

External fault of long distance:

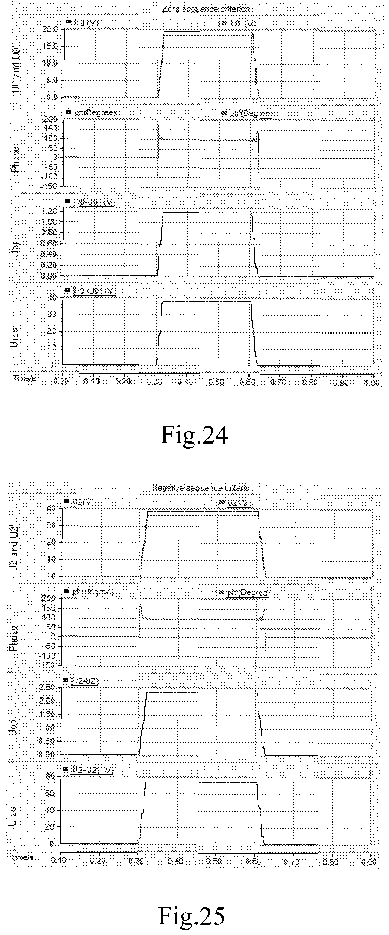

When single-phase ground fault happened to the transmission lines with very long distance, the related waveform is shown in figure 24-25. Under the condition, although the magnitude of $\dot{U}_0$ and $\dot{U}_0'$ is very small, $\dot{U}_0$ still equals to the virtual zero sequence voltage $\dot{U}_0'$. $|\dot{U}_0-\dot{U}_0'|$ is close to zero and $|\dot{U}_0+\dot{U}_0'|$ is approximately equal to double $|\dot{U}_0|$, so the operation quantity $U_{op}$ is still far less than the restraint quantity $U_{res}$. The negative sequence criterion has the same results. Protection will still not operate.

Two phase operation and single-phase reclosing for transmission lines:

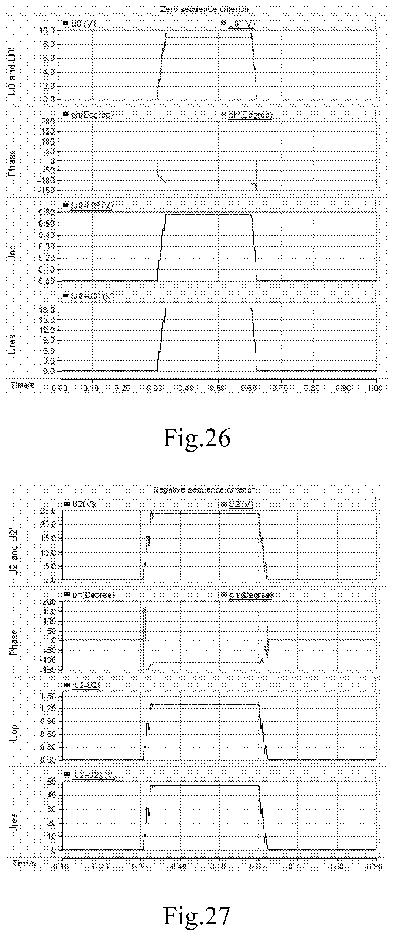

Under condition of two phase operation and single-phase reclosing, the waveforms of zero sequence voltage $\dot{U}_0$, the virtual zero sequence voltage $\dot{U}_0'$, operation quantity $\dot{U}_{op}$ and restraint quantity $\dot{U}_{res}$ are shown in figure 26-27. Neither two phase operation nor single-phase reclosing, the equivalent source of the zero sequence network locate out of the reactor. This circumstance is like to an external fault. So $|\dot{U}_0-\dot{U}_0'|$ is approximately zero and $|\dot{U}_0+\dot{U}_0'|$ is approximately equal to double $|\dot{U}_0|$. As a result, the operation quantity $U_{op}$ is still far less than the restraint quantity $U_{res}$. The negative sequence criterion has the same results. Protection will still not operate.

External fault of long distance when the transformer has a rather small reactance:

When external long distance fault occurs, and the zero sequence impedance of transformer is just rather small, it will shunt majority of the zero sequence current. As a consequence, it may result in a very small zero sequence current flowing into the reactor. These circumstance may make the value of zero sequence voltage $\dot{U}_0$, virtual zero sequence voltage $\dot{U}_0'$, operation quantity $U_{op}$ and restraint quantity $U_{res}$ to be relatively small, affecting the correct judgment of protection criterion.

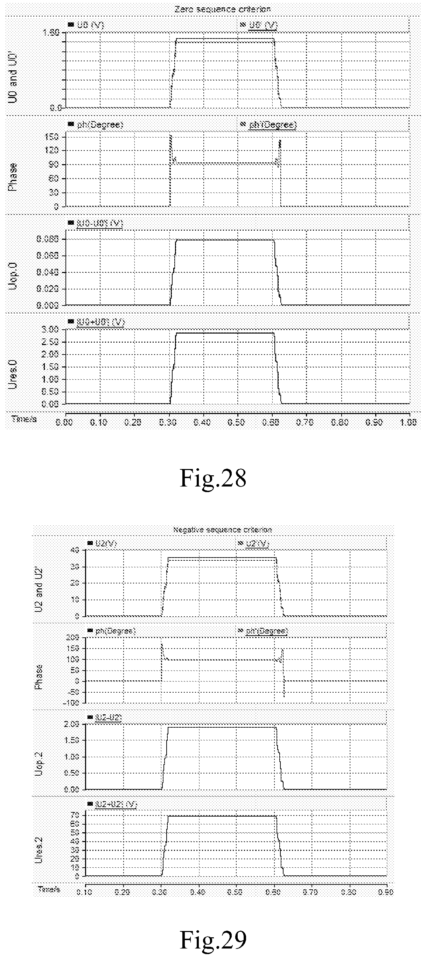

Waveform diagrams of each variable in such conditions are shown in figure 28-29, this time due to the shunt effect, although the terminal voltage $\dot{U}_0$ and the virtual zero sequence compensation voltage $\dot{U}_0{}'$ of the reactor are very small, they are almost equal. So their difference $|\dot{U}_0 - \dot{U}_0{}'|$ is almost equal to zero and $|\dot{U}_0 + \dot{U}_0{}'|$ is approximately equal to double $|\dot{U}_0|$, the operation quantity $U_{op}$ is still far less than the restraint quantity $U_{res}$. The negative sequence criterion has the same results. Protection will still not operate.

According to digital simulation, the proposed algorithm which directly compares the measured zero sequence voltage and calculated virtual zero sequence voltage, can identify the external fault, inter-turn fault and abnormal operation accurately in cooperated with the negative sequence protection criterion. Compared with the traditional scheme, the proposed principle is simple, intuitive, less affected by the variance of system operating mode and has higher sensitivity and reliability.

Digital simulation experiments show that, the present invention, which directly compares the terminal zero-sequence voltage and virtual zero-sequence voltage, can differentiate among external fault, inter-turn fault and abnormal operation accurately in cooperation with the negative sequence protection criterion.

Compared with the previous protection program, the principle of the present invention is simple, intuitive, less affected by the variance of system operating mode and has higher sensitivity and reliability. Especially compared with the principle of zero-sequence voltage magnitude, the present invention can not only compare amplitudes, but also compare phases, which is an ideal inter-turn protection program for reactors.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

**Claims**

**1.** A method of reactor turn-to-turn protection, comprising:

determining a virtual zero sequence voltage $(\dot{U}_0{}')$ based on an actual zero sequence current $(\dot{I}_{0f})$;

and/or determining a virtual negative sequence voltage $(\dot{U}_2{}')$ based on an actual negative sequence current $(\dot{I}_{2f})$;

determining a zero sequence operation quantity $(U_{op.0})$ and a zero sequence restraining quantity $(U_{res.0})$ based on an actual zero sequence voltage $(\dot{U}_0)$ and the virtual zero sequence voltage $(\dot{U}_0{}')$; and/or determining a negative sequence operation quantity $(U_{op.2})$ and a negative sequence restraining quantity $(U_{res.2})$ based on an actual negative sequence voltage $(\dot{U}_2)$ and the virtual negative sequence voltage $(\dot{U}_2{}')$; and

performing a turn-to-turn protection when the zero sequence operation quantity $(U_{op.0})$ is greater than the zero sequence restraining quantity $(U_{res.0})$, and/or when the negative sequence operation quantity $(U_{op.2})$ is greater than the negative sequence restraining quantity $(U_{res.2})$;

calculating the virtual zero sequence voltage $\dot{U}_0{}'$,

$$\dot{U}_0{}' = -\dot{I}_{0f}(Z_L + Z_{s0}{}') \; ;$$

Wherein $\dot{I}_{0f}$ represents the actual zero sequence current, $Z_L$ represents phase reactance of the reactor, $Z_{s0}{}'$ represents neutral point reactance;

calculating the virtual negative sequence voltage $\dot{U}_2{}'$;

$$\dot{U}_2{}' = -\dot{I}_{2f}\, \dot{Z}_{\mathrm{L}};$$

$\dot{I}_{2f}$ represents the actual negative sequence current, $Z_{\mathrm{L}}$ represents phase reactance of the reactor;

$$U_{op.0} = |\dot{U}_0 - \dot{U}_0{'}|,\ U_{res.0} = |\dot{U}_0 + \dot{U}_0{'}|;$$

$U_{op.0}$ represents the zero sequence operation quantity, $U_{res.0}$ represents the zero sequence restraining quantity, $\dot{U}_0$ represents the actual zero sequence voltage, $\dot{U}_0{'}$ represents the virtual zero sequence voltage;

$$U_{op.2} = |\dot{U}_2 - \dot{U}_2'|;$$

$$U_{res.2} = |\dot{U}_2 + \dot{U}_2'|;$$

$U_{op.2}$ represents the negative sequence operation quantity, $U_{res.2}$ represents the negative sequence restraining quantity, $\dot{U}_2$ represents the actual negative sequence voltage, $\dot{U}_2'$ represents the virtual negative sequence voltage.

2. The method according to claim 1, wherein comprising:

acquiring a phase voltage of high voltage end of the reactor and a phase current of low voltage end of the reactor; determining the actual zero sequence voltage $(\dot{U}_0)$ based on the phase voltage of high voltage end, determining the actual zero sequence current $(\dot{I}_{0f})$ based on the phase current of low voltage end.

3. The method according to claim 1, wherein comprising:

acquiring a phase voltage of high voltage end of the reactor and a phase current of low voltage end of the reactor; determining the actual negative sequence voltage $(\dot{U}_2)$ based on the phase voltage of high voltage end, determining the actual negative sequence current $(\dot{I}_{2f})$ based on the phase current of low voltage end.

4. The method according to claim 1, wherein comprising:

acquiring an open triangle zero sequence voltage of the high voltage as the actual zero sequence voltage $(\dot{U}_0)$ acquiring a CT zero sequence current of the neutral point of the reactor as the actual zero sequence current $(\dot{I}_{0f})$.

5. The method according to claim 1, wherein comprising:

judging whether the zero sequence operation quantity $(U_{op.0})$ is greater than the zero sequence restraining quantity ($U_{res.0}$), when the actual zero sequence voltage $(\dot{U}_0)$ is greater than a predetermined zero sequence voltage threshold value, and performing the turn-to-turn protection when the zero sequence operation quantity ($U_{op.0}$) is greater than the zero sequence restraining quantity ($U_{res.0}$); or

judging whether the zero sequence operation quantity ($U_{op.0}$) is greater than the zero sequence restraining quantity ($U_{res.0}$), when the actual zero sequence current $(\dot{I}_{0f})$ is greater than a predetermined zero sequence current threshold value, and performing the turn-to-turn protection when the zero sequence operation quantity ($U_{op.0}$) is greater than the zero sequence restraining quantity ($U_{res.0}$); or

judging whether the zero sequence operation quantity ($U_{op.0}$) is greater than the zero sequence restraining quantity ($U_{res.0}$) when the actual zero sequence current $(\dot{I}_{0f})$ is greater than a predetermined zero sequence current threshold value and the actual zero sequence voltage $(\dot{U}_0)$ is greater than a predetermined zero sequence voltage threshold value, and performing the turn-to-turn protection when the zero sequence operation quantity ($U_{op.0}$) is greater than the zero sequence restraining quantity ($U_{res.0}$).

6. The method according to claim 1, wherein comprising:

judging whether the negative sequence operation quantity ($U_{op.2}$) is greater than the negative sequence restraining quantity ($U_{res.2}$) when the actual negative sequence voltage $(\dot{U}_2)$ is greater than a predetermined negative sequence voltage threshold value, and performing the turn-to-turn protection when the negative sequence operation quantity ($U_{op.2}$) is greater than the negative sequence restraining quantity ($U_{res.2}$); or

judging whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value, and performing the turn-to-turn protection when the negative sequence operation quantity ($U_{op.2}$) is greater than the negative sequence restraining quantity ($U_{res.2}$); or

judging whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value and the actual negative sequence voltage $(\dot{U}_2)$ is greater than a predetermined negative sequence voltage threshold value, and performing the turn-to-turn protection when the negative sequence operation quantity ($U_{op.2}$) is greater than the negative sequence restraining quantity ($U_{res.2}$).

7. An apparatus of reactor turn-to-turn protection, comprising:

a virtual voltage determining unit, adapted to determine a virtual zero sequence voltage ($\dot{U}_0{}'$) based on an actual zero sequence current $(\dot{I}_{0f});$ and/or determining a virtual negative sequence voltage $(\dot{U}_2{}')$ based on an actual negative sequence current $(\dot{I}_{2f});$

an operation quantity and restraining quantity determining unit, adapted to determine a zero sequence operation quantity ($U_{op.0}$) and a zero sequence restraining quantity ($U_{res.0}$) based on an actual zero sequence voltage $(\dot{U}_0)$ and the virtual zero sequence voltage ($\dot{U}_0{}'$); and/or determine a negative sequence operation quantity

($U_{op.2}$) and a negative sequence restraining quantity ($U_{res.2}$) based on an actual negative sequence voltage

($\dot{U}_2$) and the virtual negative sequence voltage ($\dot{U}_2{}'$); and

a performing unit, adapted to perform a turn-to-turn protection when the zero sequence operation quantity ($U_{op.0}$) is greater than the zero sequence restraining quantity ($U_{res.0}$) and/or when the negative sequence operation quantity ($U_{op.2}$) is greater than the negative sequence restraining quantity ($U_{res.2}$); the virtual voltage determining unit, adapted to calculate the virtual zero sequence voltage $U_0$',

$$\dot{U}_0' = -\dot{I}_{0f}(\bar{Z}_L + \bar{Z}_{s0}) \; ;$$

Wherein $I_{0f}$ represents the actual zero sequence current, $Z_L$ represents phase reactance of the reactor, $Z_{s0}$ represents neutral point reactance; the virtual voltage determining unit, further adapted to calculate the virtual negative sequence voltage $U_2$ ;

$U_2 = -I_{2f}Z_L$; wherein $I_{2f}$ represents the actual negative sequence current, $Z_L$ represents phase reactance of the reactor; and wherein

$$U_{op.0} = |\dot{U}_0 - U_0'| , \; U_{res.0} = |\dot{U}_0 + U_0'| \; ;$$

$U_{op.0}$ represents the zero sequence operation quantity, $U_{res.0}$ represents the zero sequence restraining quantity, $\dot{U}_0$ represents the actual zero sequence voltage, $U_0$' represents the virtual zero sequence voltage; and wherein

$$U_{op.2} = |U_2 - U_2'| \; ;$$

$$U_{res.2} = |\bar{U}_2 + \bar{U}_2'| \; ;$$

$U_{op.2}$ represents the negative sequence operation quantity, $U_{res.2}$ represents the negative sequence restraining quantity, $U_2$ represents the actual negative sequence voltage, $\bar{U}_2'$ represents the virtual negative sequence voltage.

8. The apparatus according to claim 7, further comprising:
   an acquiring unit, adapted to acquire a phase voltage of high voltage end of the reactor and a phase current of low voltage end of the reactor , to determine the actual zero sequence voltage ($\dot{U}_0$) based on the phase voltage of high voltage end, and to determine the actual zero sequence current ($\dot{I}_{0f}$) based on the phase current of low voltage end.

9. The apparatus according to claim 7, further comprising:
   an acquiring unit, adapted to acquire a phase voltage of high voltage end of the reactor and a phase current of low voltage end of the reactor and to determine the actual negative sequence voltage ($\dot{U}_2$) based on the phase voltage of high voltage end, and to determine the actual negative sequence current ($\dot{I}_{2f}$) based on the phase current of low voltage end.

10. The apparatus according to claim 7, further comprising:
    an acquiring unit, adapted to acquire an open triangle zero sequence voltage of the high voltage as the actual zero sequence voltage ($\dot{U}_0$), and to acquire a CT zero sequence current of the neutral point of the reactor as the actual zero sequence current $(\dot{I}_{0f})$.

11. The apparatus according to claim 7, wherein
the performing unit, adapted to:

judge whether the zero sequence operation quantity ($U_{op.0}$) is greater than the zero sequence restraining quantity ($U_{res.0}$) when the actual zero sequence voltage $(\dot{U}_0)$ is greater than a predetermined zero sequence voltage threshold value, and perform the turn-to-turn protection when the zero sequence operation quantity ($U_{op.0}$) is greater than the zero sequence restraining quantity ($U_{res.0}$); or
judge whether the zero sequence operation quantity ($U_{op.0}$) is greater than the zero sequence restraining quantity ($U_{res.0}$) when the actual zero sequence current $(\dot{I}_{0f})$ is greater than a predetermined zero sequence current threshold value, and perform the turn-to-turn protection when the zero sequence operation quantity ($U_{op.0}$) is greater than the zero sequence restraining quantity ($U_{res.0}$); or
judge whether the zero sequence operation quantity ($U_{op.0}$) is greater than the zero sequence restraining quantity ($U_{res.0}$) when the actual zero sequence current $(\dot{I}_{0f})$ is greater than a predetermined zero sequence current threshold value and the actual zero sequence voltage $(\dot{U}_0)$ is greater than a predetermined zero sequence voltage threshold value, and perform the turn-to-turn protection when the zero sequence operation quantity ($U_{op.0}$) is greater than the zero sequence restraining quantity ($U_{res.0}$).

12. The apparatus according to claim 7, wherein
the performing unit, adapted to:

judge whether the negative sequence operation quantity ($U_{op.2}$) is greater than the negative sequence restraining quantity ($U_{res.2}$) when the actual negative sequence voltage $(\dot{U}_2)$ is greater than a predetermined negative sequence voltage threshold value, and perform the turn-to-turn protection when the negative sequence operation quantity ($U_{op.2}$) is greater than the negative sequence restraining quantity ($U_{res.2}$); or
judge whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value, and perform the turn-to-turn protection when the negative sequence operation quantity ($U_{op.2}$) is greater than the negative sequence restraining quantity ($U_{res.2}$); or
judge whether the negative sequence operation quantity ($U_{op.2}$) is greater than the negative sequence restraining quantity ($U_{res.2}$) when the actual negative sequence current $(\dot{I}_{2f})$ is greater than a predetermined negative sequence current threshold value and the actual negative sequence voltage $(\dot{U}_2)$ is greater than a predetermined negative sequence voltage threshold value, and perform the turn-to-turn protection when the negative sequence operation quantity ($U_{op.2}$) is greater than the negative sequence restraining quantity ($U_{res.2}$).

**Patentansprüche**

1. Verfahren zum Reaktorwindungsschutz, umfassend:

Bestimmen einer virtuellen Nullsystemspannung $(\dot{U}_0')$ auf Basis eines tatsächlichen Nullsystemstroms $(\dot{I}_{0f})$; und/oder Bestimmen einer virtuellen Gegensystemspannung $(\dot{U}_2')$ auf Basis eines tatsächlichen Gegensystemstroms $(\dot{I}_{2f})$;

Bestimmen einer Nullsystembetriebsgröße ($U_{op.0}$) und einer Nullsystemstabilisierungsgröße ($U_{res.0}$) auf Basis einer tatsächlichen Nullsystemspannung $(\dot{U}_0)$ und der virtuellen Nullsystemspannung $(\dot{U}_0')$; und/oder Bestimmen einer Gegensystembetriebsgröße ($U_{op.2}$) und einer Gegensystemstabilisierungsgröße ($U_{res.2}$) auf Basis einer tatsächlichen Gegensystemspannung $(\dot{U}_2)$ und der virtuellen Gegensystemspannung $(\dot{U}_2')$; und

Durchführen eines Windungsschutzes, wenn die Nullsystembetriebsgröße ($U_{op.0}$) größer ist als die Nullsystemstabilisierungsgröße ($U_{res.0}$) und/oder wenn die Gegensystembetriebsgröße ($U_{op.2}$) größer ist als die Gegensystemstabilisierungsgröße ($U_{res.2}$);

Berechnen der virtuellen Nullsystemspannung $\dot{U}_0'$,

$$\dot{U}_0' = -\dot{I}_{0f}(Z_L + Z_{s0}');$$

wobei $\dot{I}_{0f}$ den tatsächlichen Nullsystemstrom darstellt, $Z_L$ die Phasenreaktanz des Reaktors darstellt, $Z_{s0}'$ die Sternpunktreaktanz darstellt;

Berechnen der virtuellen Gegensystemspannung $\dot{U}_2'$;

$$\dot{U}_2' = -\dot{I}_{2f} Z_L;$$

$\dot{I}_{2f}$ den tatsächlichen Gegensystemstrom darstellt, $Z_L$ die Phasenreaktanz des Reaktors darstellt;

$$U_{op.0} = |\dot{U}_0 - \dot{U}_0'|; \quad U_{res.0} = |\dot{U}_0 + \dot{U}_0'|;$$

$U_{op.0}$ die Nullsystembetriebsgröße darstellt, $U_{res.0}$ die Nullsystemstabilisierungsgröße darstellt, $\dot{U}_0$ die tatsäch-

liche Nullsystemspannung darstellt, $\dot{U}_0'$ die virtuelle Nullsystemspannung darstellt;

$$U_{op.2} = |\dot{U}_2 - \dot{U}_2'|;$$

$$U_{res.2} = |\dot{U}_2 + \dot{U}_2'|;$$

$U_{op.2}$ die Gegensystembetriebsgröße darstellt, $U_{res.2}$ die Gegensystemstabilisierungsgröße darstellt, $\dot{U}_2$

die tatsächliche Gegensystemspannung darstellt, $\dot{U}_2'$ die virtuelle Gegensystemspannung darstellt.

2.  Verfahren nach Anspruch 1, wobei umfassend:

Erfassen einer Phasenspannung eines Hochspannungsendes des Reaktors und eines Phasenstroms des Niederspannungsendes des Reaktors;

Bestimmen der tatsächlichen Nullsystemspannung $(\dot{U}_0)$ auf Basis der Phasenspannung des Hochspannungsendes, Bestimmen des tatsächlichen Nullsystemstroms $(\dot{I}_{0f})$ auf Basis des Phasenstroms des Niederspannungsendes.

3.  Verfahren nach Anspruch 1, wobei umfassend:

Erfassen einer Phasenspannung eines Hochspannungsendes des Reaktors und eines Phasenstroms des Niederspannungsendes des Reaktors;

Bestimmen der tatsächlichen Gegensystemspannung $(\dot{U}_2)$ auf Basis der Phasenspannung des Hochspannungsendes, Bestimmen des tatsächlichen Gegensystemstroms $(\dot{I}_{2f})$ auf Basis des Phasenstroms des Niederspannungsendes.

4.  Verfahren nach Anspruch 1, wobei umfassend:
Erfassen einer Offenes-Dreieck-Nullsystemspannung der Hochspannung als die tatsächliche Nullsystemspannung

$(\dot{U}_0)$ und Erfassen eines CT-Nullsystemstroms des Sternpunkts des Reaktors als der tatsächliche Nullsys

temstrom $(\dot{I}_{0f})$.

**5.** Verfahren nach Anspruch 1, wobei umfassend:

Beurteilen, ob die Nullsystembetriebsgröße ($U_{op.0}$) größer ist als die Nullsystemstabilisierungsgröße ($U_{res.0}$),

wenn die tatsächliche Nullsystemspannung $(\dot{U}_0)$ größer ist als ein vorbestimmter Nullsystemspannungsschwellwert, und Durchführen des Windungsschutzes, wenn die Nullsystembetriebsgröße ($U_{op.0}$) größer ist als die Nullsystemstabilisierungsgröße ($U_{res.0}$); oder

Beurteilen, ob die Nullsystembetriebsgröße ($U_{op.0}$) größer ist als die Nullsystemstabilisierungsgröße ($U_{res.0}$),

wenn der tatsächliche Nullsystemstrom $(\dot{I}_{0f})$ größer ist als ein vorbestimmter Nullsystemstromschwellwert, und Durchführen des Windungsschutzes, wenn die Nullsystembetriebsgröße ($U_{op.0}$) größer ist als die Nullsystemstabilisierungsgröße ($U_{res.0}$); oder

Beurteilen, ob die Nullsystembetriebsgröße ($U_{op.0}$) größer ist als die Nullsystemstabilisierungsgröße ($U_{res.0}$),

wenn der tatsächliche Nullsystemstrom $(\dot{I}_{0f})$ größer ist als ein vorbestimmter Nullsystemstromschwellwert und die tatsächliche Nullsystemspannung $(\dot{U}_0)$ größer ist als ein vorbestimmter Nullsystemspannungsschwellwert, und Durchführen des Windungsschutzes, wenn die Nullsystembetriebsgröße ($U_{op.0}$) größer ist als die Nullsystemstabilisierungsgröße ($U_{res.0}$).

**6.** Verfahren nach Anspruch 1, wobei umfassend:

Beurteilen, ob die Gegensystembetriebsgröße ($U_{op.2}$) größer ist als die Gegensystemstabilisierungsgröße

($U_{res.2}$), wenn die tatsächliche Gegensystemspannung $(\dot{U}_2)$ größer ist als ein vorbestimmter Gegensystemspannungsschwellwert, und Durchführen des Windungsschutzes, wenn die Gegensystembetriebsgröße ($U_{op.2}$) größer ist als die Gegensystemstabilisierungsgröße ($U_{res.2}$); oder

Beurteilen, ob die Gegensystembetriebsgröße ($U_{op.2}$) größer ist als die Gegensystemstabilisierungsgröße

($U_{res.2}$), wenn der tatsächliche Gegensystemstrom $(\dot{I}_{2f})$ größer ist als ein vorbestimmter Gegensystemstromschwellwert, und Durchführen des Windungsschutzes, wenn die Gegensystembetriebsgröße ($U_{op.2}$) größer ist als die Gegensystemstabilisierungsgröße ($U_{res.2}$); oder

Beurteilen, ob die Gegensystembetriebsgröße ($U_{op.2}$) größer ist als die Gegensystemstabilisierungsgröße

($U_{res.2}$), wenn der tatsächliche Gegensystemstrom $(\dot{I}_{2f})$ größer ist als ein vorbestimmter Gegensystemstromschwellwert und die tatsächliche Gegensystemspannung $(\dot{U}_2)$ größer ist als ein vorbestimmter Gegensystemspannungsschwellwert, und Durchführen des Windungsschutzes, wenn die Gegensystembetriebsgröße ($U_{op.2}$) größer ist als die Gegensystemstabilisierungsgröße ($U_{res.2}$).

**7.** Vorrichtung für einen Reaktorwindungsschutz, umfassend:

eine Virtuelle-Spannung-Bestimmungseinheit, ausgelegt zum Bestimmen einer virtuellen Nullsystemspannung $(\dot{U}_0{}')$ auf Basis eines tatsächlichen Nullsystemstroms $(\dot{I}_{0f})$; und/oder Bestimmen einer virtuellen Gegensystemspannung $(\dot{U}_2{}')$ auf Basis eines tatsächlichen Gegensystemstroms $(\dot{I}_{2f})$;

eine Betriebsgrößen- und Stabilisierungsgrößenbestimmungseinheit, ausgelegt zum Bestimmen einer Nullsystembetriebsgröße ($U_{op.0}$) und einer Nullsystemstabilisierungsgröße ($U_{res.0}$) auf Basis einer tatsächlichen Nullsystemspannung $(\dot{U}_0)$ und der virtuellen Nullsystemspannung $(\dot{U}_0{}')$; und/oder Bestimmen einer Gegensystembetriebsgröße ($U_{op.2}$) und einer Gegensystemstabilisierungsgröße ($U_{res.2}$) auf Basis einer tatsächlichen Gegensystemspannung $(\dot{U}_2)$ und der virtuellen Gegensystemspannung $(\dot{U}_2{}')$;

und

eine Durchführungseinheit, ausgelegt zum Durchführen eines Windungsschutzes, wenn die Nullsystembetriebsgröße ($U_{op.0}$) größer ist als die Nullsystemstabilisierungsgröße ($U_{res.0}$), und/oder wenn die Gegensystembetriebsgröße ($U_{op.2}$) größer ist als die Gegensystemstabilisierungsgröße ($U_{res.2}$);

die Virtuelle-Spannung-Bestimmungseinheit, ausgelegt zum Berechnen der virtuellen Nullsystemspannung $\dot{U}_0{}'$,

$$\dot{U}_0{}' = -\dot{I}_{0f}(Z_{\mathrm{L}} + Z_{s0}{}');$$

wobei $I_{0f}$ den tatsächlichen Nullsystemstrom darstellt, $Z_{\mathrm{L}}$ die Phasenreaktanz des Reaktors darstellt, $Z_{s0}{}'$ die Sternpunktreaktanz darstellt;

die Virtuelle-Spannung-Bestimmungseinheit, weiterhin ausgelegt zum Berechnen der virtuellen Gegensystemspannung $U_2$;

$$U_2 = -I_{2f}Z_{\mathrm{L}};$$

$I_{2f}$ den tatsächlichen Gegensystemstrom darstellt, $Z_{\mathrm{L}}$ die Phasenreaktanz des Reaktors darstellt;

$$U_{op.0} = |U_0 - U_0{}'|, \quad U_{res.0} = |U_0 + U_0{}'|;$$

$U_{op.0}$ die Nullsystembetriebsgröße darstellt, $U_{res.0}$ die Nullsystemstabilisierungsgröße darstellt, $\dot{U}_0$ die tatsächliche Nullsystem darstellt, $U_0{}'$ das virtuelle Nullsystem darstellt;

$$U_{op.2} = |U_2 - U_2{}'|;$$

$$U_{res.2} = |\dot{U}_2 + \dot{U}_2'|;$$

$U_{op.2}$ die Gegensystembetriebsgröße darstellt, $U_{res.2}$ die Gegensystemstabilisierungsgröße darstellt, $\dot{U}_2$

die tatsächliche Gegensystemspannung darstellt, $\dot{U}_2'$ die virtuelle Gegensystemspannung darstellt.

**8.** Vorrichtung nach Anspruch 7, weiterhin umfassend:
eine Erfassungseinheit, ausgelegt zum Erfassen einer Phasenspannung eines Hochspannungsendes des Reaktors und eines Phasenstroms des Niederspannungsendes des Reaktors, zum Bestimmen der tatsächlichen Nullsystemspannung $(\dot{U}_0)$ auf Basis der Phasenspannung des Hochspannungsendes und zum Bestimmen des tatsächlichen Nullsystemstroms $(\dot{I}_{0f})$ auf Basis des Phasenstroms des Niederspannungsendes.

**9.** Vorrichtung nach Anspruch 7, weiterhin umfassend:
eine Erfassungseinheit, ausgelegt zum Erfassen einer Phasenspannung eines Hochspannungsendes des Reaktors und eines Phasenstroms des Niederspannungsendes des Reaktors und zum Bestimmen der tatsächlichen Gegensystemspannung $(\dot{U}_2)$ auf Basis der Phasenspannung des Hochspannungsendes und zum Bestimmen des tatsächlichen Gegensystemstroms $(\dot{I}_{2f})$ auf Basis des Phasenstroms des Niederspannungsendes.

**10.** Vorrichtung nach Anspruch 7, weiterhin umfassend:
eine Erfassungseinheit, ausgelegt zum Erfassen einer Offenes-Dreieck-Nullsystemspannung der Hochspannung als die tatsächliche Nullsystemspannung $(\dot{U}_0)$ und Erfassen eines CT-Nullsystemstroms des Sternpunkts des Reaktors als der tatsächliche Nullsystemstrom $(\dot{I}_{0f})$.

**11.** Vorrichtung nach Anspruch 7, wobei
die Durchführungseinheit ausgelegt ist zum Beurteilen, ob die Nullsystembetriebsgröße ($U_{op.0}$) größer ist als die Nullsystemstabilisierungsgröße ($U_{res.0}$), wenn die tatsächliche Nullsystemspannung $(\dot{U}_0)$ größer ist als ein vorbestimmter Nullsystemspannungsschwellwert, und Durchführen des Windungsschutzes, wenn die Nullsystembetriebsgröße ($U_{op.0}$) größer ist als die Nullsystemstabilisierungsgröße ($U_{res.0}$); oder
Beurteilen, ob die Nullsystembetriebsgröße ($U_{op.0}$) größer ist als die Nullsystemstabilisierungsgröße ($U_{res.0}$), wenn der tatsächliche Nullsystemstrom $(\dot{I}_{0f})$ größer ist als ein vorbestimmter Nullsystemstromschwellwert, und Durchführen des Windungsschutzes, wenn die Nullsystembetriebsgröße ($U_{op.0}$) größer ist als die Nullsystemstabilisierungsgröße ($U_{res.0}$); oder

Beurteilen, ob die Nullsystembetriebsgröße ($U_{op.0}$) größer ist als die Nullsystemstabilisierungsgröße ($U_{res.0}$), wenn

der tatsächliche Nullsystemstrom $(\dot{I}_{0f})$ größer ist als ein vorbestimmter Nullsystemstromschwellwert und

die tatsächliche Nullsystemspannung $(\dot{U}_0)$ größer ist als ein vorbestimmter Nullsystemspannungsschwellwert, und Durchführen des Windungsschutzes, wenn die Nullsystembetriebsgröße ($U_{op.0}$) größer ist als die Nullsystemstabilisierungsgröße ($U_{res.0}$).

**12.** Vorrichtung nach Anspruch 7, wobei

die Durchführungseinheit ausgelegt ist zum: Beurteilen, ob die Gegensystembetriebsgröße ($U_{op.2}$) größer ist als die Gegensystemstabilisierungsgröße ($U_{res.2}$), wenn die tatsächliche Gegensystemspannung $(\dot{U}_2)$ größer ist als ein vorbestimmter Gegensystemspannungsschwellwert, und Durchführen des Windungsschutzes, wenn die Gegensystembetriebsgröße ($U_{op.2}$) größer ist als die Gegensystemstabilisierungsgröße ($U_{res.2}$); oder

Beurteilen, ob die Gegensystembetriebsgröße ($U_{op.2}$) größer ist als die Gegensystemstabilisierungsgröße ($U_{res.2}$),

wenn der tatsächliche Gegensystemstrom $(\dot{I}_{2f})$ größer ist als ein vorbestimmter Gegensystemstromschwellwert, und Durchführen des Windungsschutzes, wenn die Gegensystembetriebsgröße ($U_{op.2}$) größer ist als die Gegensystemstabilisierungsgröße ($U_{res.2}$); oder

Beurteilen, ob die Gegensystembetriebsgröße ($U_{op.2}$) größer ist als die Gegensystemstabilisierungsgröße ($U_{res.2}$),

wenn der tatsächliche Gegensystemstrom $(\dot{I}_{2f})$ größer ist als ein vorbestimmter Gegensystemstromschwellwert und die tatsächliche Gegensystemspannung $(\dot{U}_2)$ größer ist als ein vorbestimmter Gegensystemspannungsschwellwert, und Durchführen des Windungsschutzes, wenn die Gegensystembetriebsgröße ($U_{op.2}$) größer ist als die Gegensystemstabilisierungsgröße ($U_{res.2}$).

**Revendications**

**1.** Procédé de protection tour à tour de réacteur, comprenant les étapes consistant à :

déterminer une tension de séquence zéro virtuelle $(\dot{U}_0{}')$ d'après un courant de séquence zéro réel

$(\dot{I}_{0f})$ ; et/ou déterminer une tension de séquence négative virtuelle $(\dot{U}_2{}')$ d'après un courant de

séquence négative réel $(\dot{I}_{2f})$ ;

déterminer une quantité d'opération de séquence zéro ($U_{op,0}$) et une quantité de restriction de séquence zéro

($U_{res,0}$) d'après une tension de séquence zéro réelle ($\dot{U}_0$) et la tension de séquence zéro virtuelle ($\dot{U}_0'$) ; et/ou déterminer une quantité d'opération de séquence négative ($U_{op,2}$) et une quantité de restriction de séquence négative ($U_{res,2}$) d'après une tension de séquence négative réelle ($\dot{U}_2$) et la tension de séquence négative virtuelle ($\dot{U}_2'$) ; et

effectuer une protection tour à tour lorsque la quantité d'opération de séquence zéro ($U_{op,0}$) est supérieure à la quantité de restriction de séquence zéro ($U_{res,0}$), et/ou lorsque la quantité d'opération de séquence négative ($U_{op,2}$) est supérieure à la quantité de restriction de séquence négative ($U_{res,2}$) ;

calculer la tension de séquence zéro virtuelle $\dot{U}_0'$,

$$\dot{U}_0' = -\dot{I}_{0f}(Z_L + Z_{s0}') \; ;$$

ou $\dot{I}_{0f}$ représente le courant de séquence zéro réel, $Z_L$ représente la réactance de phase du réacteur, $Z_{s0}'$ représente la réactance de point neutre ;

calculer la tension de séquence négative virtuelle $\dot{U}_2'$ ;

$$\dot{U}_2' = -\dot{I}_{2f} Z_L$$

$\dot{I}_{2f}$ représente le courant de séquence négative réel, $Z_L$ représente la réactance de phase du réacteur ;

$$U_{op,0} = |\dot{U}_0 - \dot{U}_0'|, U_{res,0} = |\dot{U}_0 + \dot{U}_0'| \; ;$$

$U_{op,0}$ représente la quantité d'opération de séquence zéro, $U_{res,0}$ représente la quantité de restriction de séquence zéro, $\dot{U}_0$ représente la tension de séquence zéro réelle, $\dot{U}_0'$ représente la tension de séquence zéro virtuelle ;

$$U_{op,2} = |\dot{U}_2 - \dot{U}_2'| \; ;$$

$$U_{res,2} = |\dot{U}_2 + \dot{U}_2'| \; ;$$

$U_{op,2}$ représente la quantité d'opération de séquence négative, $U_{res,2}$ représente la quantité de restriction de séquence négative, $\dot{U}_2$ représente la tension de séquence négative réelle, $\dot{U}_2'$ représente la tension de séquence négative virtuelle.

2. Procédé selon la revendication 1, comprenant les étapes consistant à :

acquérir une tension de phase d'une extrémité haute tension du réacteur et un courant de phase d'une extrémité basse tension du réacteur ;

déterminer la tension de séquence zéro réelle $(\overset{*}{U}_0)$ d'après la tension de phase de l'extrémité haute tension, déterminer le courant de séquence zéro réel $(\overset{*}{I}_{0f})$ d'après le courant de phase de l'extrémité basse tension.

3. Procédé selon la revendication 1, comprenant les étapes consistant à :

acquérir une tension de phase d'une extrémité haute tension du réacteur et un courant de phase d'une extrémité basse tension du réacteur ;

déterminer la tension de séquence négative réelle $(\overset{*}{U}_2)$ d'après la tension de phase de l'extrémité haute tension, déterminer le courant de séquence négative réel $(\overset{*}{I}_{2f})$ d'après le courant de phase de l'extrémité basse tension.

4. Procédé selon la revendication 1, comprenant les étapes consistant à :
acquérir une tension de séquence zéro de triangle ouvert de la haute tension comme tension de séquence zéro réelle $(\overset{*}{U}_0)$ et acquérir un courant de séquence zéro CT du point neutre du réacteur comme courant de séquence zéro réel $(\overset{*}{I}_{0f})$.

5. Procédé selon la revendication 1, comprenant les étapes consistant à :

déterminer si la quantité d'opération de séquence zéro ($U_{op,0}$) est supérieure à la quantité de restriction de séquence zéro ($U_{res,0}$), lorsque la tension de séquence zéro réelle $(\overset{*}{U}_0)$ est supérieure à une valeur de seuil de tension de séquence zéro prédéterminée, et effectuer la protection tour à tour lorsque la quantité d'opération de séquence zéro ($U_{op,0}$) est supérieure à la quantité de restriction de séquence zéro ($U_{res,0}$) ; ou
déterminer si la quantité d'opération de séquence zéro ($U_{op,0}$) est supérieure à la quantité de restriction de séquence zéro ($U_{res,0}$), lorsque le courant de séquence zéro réel $(\overset{*}{I}_{0f})$ est supérieur à une valeur de seuil de courant de séquence zéro prédéterminée, et effectuer la protection tour à tour lorsque la quantité d'opération de séquence zéro ($U_{op,0}$) est supérieure à la quantité de restriction de séquence zéro ($U_{res,0}$) ; ou
déterminer si la quantité d'opération de séquence zéro ($U_{op,0}$) est supérieure à la quantité de restriction de séquence zéro ($U_{res,0}$) lorsque le courant de séquence zéro réel $(\overset{*}{I}_{0f})$ est supérieur à une valeur de seuil de courant de séquence zéro prédéterminée et que la tension de séquence zéro réelle $(\overset{*}{U}_0)$ est supérieure à une valeur de seuil de tension de séquence zéro prédéterminée, et effectuer la protection tour à tour lorsque la quantité d'opération de séquence zéro ($U_{op,0}$) est supérieure à la quantité de restriction de séquence zéro ($U_{res,0}$).

**6.** Procédé selon la revendication 1, comprenant les étapes consistant à :

déterminer si la quantité d'opération de séquence négative ($U_{op,2}$) est supérieure à la quantité de restriction de séquence négative ($U_{res,2}$) lorsque la tension de séquence négative réelle ($\dot{U}_2$) est supérieure à une valeur de seuil de tension de séquence négative prédéterminée, et effectuer la protection tour à tour lorsque la quantité d'opération de séquence négative ($U_{op,2}$) est supérieure à la quantité de restriction de séquence négative ($U_{res,2}$) ; ou

déterminer si la quantité d'opération de séquence négative ($U_{op,2}$) est supérieure à la quantité de restriction de séquence négative ($U_{res,2}$) lorsque le courant de séquence négative réel ($\dot{I}_{2f}$) est supérieur à une valeur de seuil de courant de séquence négative prédéterminée, et effectuer la protection tour à tour lorsque la quantité d'opération de séquence négative ($U_{op,2}$) est supérieure à la quantité de restriction de séquence négative ($U_{res,2}$) ; ou

déterminer si la quantité d'opération de séquence négative ($U_{op,2}$) est supérieure à la quantité de restriction de séquence négative ($U_{res,2}$) lorsque le courant de séquence négative réel ($\dot{I}_{2f}$) est supérieur à une valeur de seuil de courant de séquence négative prédéterminée et que la tension de séquence négative réelle ($\dot{U}_2$) est supérieure à une valeur de seuil de tension de séquence négative prédéterminée, et effectuer la protection tour à tour lorsque la quantité d'opération de séquence négative ($U_{op,2}$) est supérieure à la quantité de restriction de séquence négative ($U_{res,2}$).

**7.** Appareil de protection tour à tour de réacteur, comprenant :

une unité de détermination de tension virtuelle, capable de déterminer une tension de séquence zéro virtuelle ($\dot{U}_0{}'$) d'après un courant de séquence zéro réel ($\dot{I}_{0f}$) ; et/ou de déterminer une tension de séquence négative virtuelle ($\dot{U}_2{}'$) d'après un courant de séquence négative réel ($\dot{I}_{2f}$) ;

une unité de détermination de quantité d'opération et de quantité de restriction, capable de déterminer une quantité d'opération de séquence zéro ($U_{op,0}$) et une quantité de restriction de séquence zéro ($U_{res,0}$) d'après une tension de séquence zéro réelle ($\dot{U}_0$) et la tension de séquence zéro virtuelle ($\dot{U}_0{}'$) ; et/ou de déterminer une quantité d'opération de séquence négative ($U_{op,2}$) et une quantité de restriction de séquence négative ($U_{res,2}$) d'après une tension de séquence négative réelle ($\dot{U}_2$) et la tension de séquence négative virtuelle ($\dot{U}_2{}'$) ; et

une unité d'exécution, capable d'effectuer une protection tour à tour lorsque la quantité d'opération de séquence zéro ($U_{op,0}$) est supérieure à la quantité de restriction de séquence zéro ($U_{res,0}$) et/ou lorsque la quantité d'opération de séquence négative ($U_{op,2}$) est supérieure à la quantité de restriction de séquence négative ($U_{res,2}$) ;

l'unité de détermination de tension virtuelle étant capable de calculer la tension de séquence zéro virtuelle $U_0{}'$,

$$\dot{U}_0{}' = -\dot{I}_{0f}(Z_L + Z_{s0}) \;;$$

ou $I_{0f}$ représente le courant de séquence zéro réel, $Z_L$ représente la réactance de phase du réacteur, $Z_{s0}$ représente la réactance de point neutre ;

l'unité de détermination de tension virtuelle étant également capable de calculer la tension de séquence négative virtuelle $U_2$ ;

$U_2 = -I_{2f} Z_L$ ; où

$I_{2f}$ représente le courant de séquence négative réel, $Z_L$ représente la réactance de phase du réacteur ; et où

$$U_{op,0} = |U_0 - U_0'| \; ; \; U_{res,0} = |U_0 + U_0'| \quad ;$$

$U_{op,0}$ représente la quantité d'opération de séquence zéro, $U_{res,0}$ représente la quantité de restriction de séquence zéro, $\dot{U}_0$ représente la tension de séquence zéro réelle, $U_0'$ représente la séquence zéro virtuelle ;

$$U_{op,2} = |U_2 - U_2'| \quad ;$$

$$U_{res,2} = |\dot{U}_2 + \dot{U}_2'| \quad ;$$

$U_{op,2}$ représente la quantité d'opération de séquence négative, $U_{res,2}$ représente la quantité de restriction de séquence négative, $U_2$ représente la tension de séquence négative réelle, $\dot{U}_2'$ représente la tension de séquence négative virtuelle.

8. Appareil selon la revendication 7, comprenant également :
une unité d'acquisition, capable d'acquérir une tension de phase d'une extrémité haute tension du réacteur et un courant de phase d'une extrémité basse tension du réacteur, de déterminer la tension de séquence zéro réelle $(\dot{U}_0)$ d'après la tension de phase de l'extrémité haute tension, et de déterminer le courant de séquence zéro réel $(\dot{I}_{0f})$ d'après le courant de phase de l'extrémité basse tension.

9. Appareil selon la revendication 7, comprenant également :
une unité d'acquisition, capable d'acquérir une tension de phase d'une extrémité haute tension du réacteur et un courant de phase d'une extrémité basse tension du réacteur et de déterminer la tension de séquence négative réelle $(\dot{U}_2)$ d'après la tension de phase de l'extrémité haute tension, et de déterminer le courant de séquence négative réel $(\dot{I}_{2f})$ d'après le courant de phase de l'extrémité basse tension.

10. Appareil selon la revendication 7, comprenant également :
une unité d'acquisition, capable d'acquérir une tension de séquence zéro de triangle ouvert de la haute tension comme tension de séquence zéro réelle $(\dot{U}_0)$, et d'acquérir un courant de séquence zéro CT du point neutre du réacteur comme courant de séquence zéro réel $(\dot{I}_{0f})$.

11. Appareil selon la revendication 7, dans lequel l'unité d'exécution est capable :

de déterminer si la quantité d'opération de séquence zéro ($U_{op,0}$) est supérieure à la quantité de restriction de séquence zéro ($U_{res,0}$) lorsque la tension de séquence zéro réelle ($\overset{\bullet}{U}_0$) est supérieure à une valeur de seuil de tension de séquence zéro prédéterminée, et d'effectuer la protection tour à tour lorsque la quantité d'opération de séquence zéro ($U_{op,0}$) est supérieure à la quantité de restriction de séquence zéro ($U_{res,0}$) ; ou

de déterminer si la quantité d'opération de séquence zéro ($U_{op,0}$) est supérieure à la quantité de restriction de séquence zéro ($U_{res,0}$), lorsque le courant de séquence zéro réel ($\overset{\bullet}{I}_{0f}$) est supérieur à une valeur de seuil de courant de séquence zéro prédéterminée, et d'effectuer la protection tour à tour lorsque la quantité d'opération de séquence zéro ($U_{op,0}$) est supérieure à la quantité de restriction de séquence zéro ($U_{res,0}$) ; ou

de déterminer si la quantité d'opération de séquence zéro ($U_{op,0}$) est supérieure à la quantité de restriction de séquence zéro ($U_{res,0}$) lorsque le courant de séquence zéro réel ($\overset{\bullet}{I}_{0f}$) est supérieur à une valeur de seuil de courant de séquence zéro prédéterminée et que la tension de séquence zéro réelle ($\overset{\bullet}{U}_0$) est supérieure à une valeur de seuil de tension de séquence zéro prédéterminée, et d'effectuer la protection tour à tour lorsque la quantité d'opération de séquence zéro ($U_{op,0}$) est supérieure à la quantité de restriction de séquence zéro ($U_{res,0}$).

12. Appareil selon la revendication 7, dans lequel l'unité d'exécution est capable :

de déterminer si la quantité d'opération de séquence négative ($U_{op,2}$) est supérieure à la quantité de restriction de séquence négative ($U_{res,2}$) lorsque la tension de séquence négative réelle ($\overset{\bullet}{U}_2$) est supérieure à une valeur de seuil de tension de séquence négative prédéterminée, et d'effectuer la protection tour à tour lorsque la quantité d'opération de séquence négative ($U_{op,2}$) est supérieure à la quantité de restriction de séquence négative ($U_{res,2}$) ; ou

de déterminer si la quantité d'opération de séquence négative ($U_{op,2}$) est supérieure à la quantité de restriction de séquence négative ($U_{res,2}$) lorsque le courant de séquence négative réel ($\overset{\bullet}{I}_{2f}$) est supérieur à une valeur de seuil de courant de séquence négative prédéterminée, et d'effectuer la protection tour à tour lorsque la quantité d'opération de séquence négative ($U_{op,2}$) est supérieure à la quantité de restriction de séquence négative ($U_{res,2}$) ; ou

de déterminer si la quantité d'opération de séquence négative ($U_{op,2}$) est supérieure à la quantité de restriction de séquence négative ($U_{res,2}$) lorsque le courant de séquence négative réel ($\overset{\bullet}{I}_{2f}$) est supérieur à une valeur de seuil de courant de séquence négative prédéterminée et que la tension de séquence négative réelle ($\overset{\bullet}{U}_2$) est supérieure à une valeur de seuil de tension de séquence négative prédéterminée, et d'effectuer la protection tour à tour lorsque la quantité d'opération de séquence négative ($U_{op,2}$) est supérieure à la quantité de restriction de séquence négative ($U_{res,2}$).

(a) Zero-sequence network

(b) The distribution of zero-sequence
voltage in turn-to-turn fault

(c) The distribution of zero-sequence voltage
in turn-to-turn fault

Fig.2

$$(a) \left| \dot{U}_{op} \right| > \left| \dot{U}_{res} \right| \qquad (b) \left| \dot{U}_{op} \right| = \left| \dot{U}_{res} \right| \qquad (c) \left| \dot{U}_{op} \right| < \left| \dot{U}_{res} \right|$$

Fig.3

| 401 | 402 | 403 |
|-----|-----|-----|
| virtual voltage determining unit | operation quantity and restraining quantity determining unit | performing unit |

Fig.4

Fig.5

Fig.6

Fig.7

Fig.8

Fig.9

Fig.10

Fig.11

Fig.12

Fig.13

Fig.14

Fig.15

Fig.16

Fig.17

Fig.18

Fig.19

Fig.20

Fig.21

Fig.22

Fig.23

Fig.24

Fig.25

Fig.26

Fig.27

Fig.28

Fig.29

**EP 3 069 426 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101651328 B
- CN 101505051 A
- CN 1555116 A